# EUROPÄISCHE PATENTSCHRIFT

(11) **EP 4 118 746 B1**
(45) Veröffentlichungstag und Bekanntmachung des Hinweises auf die Patenterteilung: **18.02.2026**
(21) Anmeldenummer: 21712728.1
(22) Anmeldetag: 08.03.2021
(51) Int. Cl.: H03K 17/975, G01P 15/125, G01D 5/241, G01D 5/24

(54) **SCHALTUNG ZUM BETREIBEN EINES KAPAZITIVEN SENSORS SOWIE ZUGEHÖRIGE SENSORVORRICHTUNG**
CIRCUIT FOR OPERATING A CAPACITIVE SENSOR AND ASSOCIATED SENSOR DEVICE
CIRCUIT POUR FAIRE FONCTIONNER UN CAPTEUR CAPACITIF ET DISPOSITIF DE DÉTECTION ASSOCIÉ

(30) Priorität: 10.03.2020 DE 102020203036
(43) Veröffentlichungstag der Anmeldung: 18.01.2023
(73) Patentinhaber: Robert Bosch GmbH, 70442 Stuttgart (DE)
(72) Erfinder: BOESER, Tobias, 70199 Stuttgart (DE); LANNIEL, Alice, 72076 Tuebingen (DE)
(86) Internationale Anmeldenummer: PCT/EP2021/055766
(87) Internationale Veröffentlichungsnummer: WO 2021/180642

(56) Entgegenhaltungen:
- EP-A2- 0 718 631
- CHINWUBA DAVID EZEKWE: "Readout Techniques for High-Q Micromachined Vibratory Rate Gyroscopes", INTERNET CITATION, 21 December 2007 (2007-12-21), pages COMPLETE, XP007911506, Retrieved from the Internet <URL:http://www.eecs.berkeley.edu/Pubs/TechRpts/2007/EECS-2007-176.pdf> [retrieved on 20100204]

## Beschreibung

### Stand der Technik

Die vorliegende Erfindung betrifft eine Schaltung zum Betreiben eines kapazitiven Sensors.

Aufgrund der geringen Größe, den geringen Kosten und dem geringen Stromverbrauch von MEMS-Sensoren ist die Nachfrage nach solchen Sensoren in den letzten Jahren stark angestiegen. Abhängig von einer Anwendung eines solchen Sensors variiert ein Design der zugehörigen Schaltungen abhängig von den gegebenen Anforderungen. Es sind unterschiedliche Arten von Schaltungen zum Betreiben kapazitiver Sensoren bekannt, welche für unterschiedliche spezifische Parameter optimiert sind. Insbesondere Schaltungen zum Betreiben von Beschleunigungssensoren können dabei in zwei Hauptgruppen unterteilt werden, welche Force-Feedback Sensoren und Open-Loop Sensoren betreffen.

Bei Force-Feedback Sensoren wird eine Gegenkraft, zumeist eine elektrostatische Kraft, aufgebracht, um einer Abweichung einer Schwungmasse von ihrer nominalen Position entgegenzuwirken, wobei in Open-Loop Sensoren die aufgehängte Schwungmasse frei beweglich ist. Durch eine Force-Feedback Implementierung wird eine Vielzahl von Eigenschaften des Sensors verbessert. So ermöglicht ein solcher Aufbau eine größere dynamische Reichweite, eine bessere Linearität, eine höhere Empfindlichkeit und eine größere Signalbandweite.

Bei der Open-Loop Architektur wird eine besonders kompakte Bauform ermöglicht und ein geringerer Verbrauch erzielt. Zudem sind Sensoren in der Open-Loop Architekturen sind einfacher zu implementieren als Force-Feedback Sensoren. Ein Kompromiss zwischen diesen Architekturen wird dadurch erzielt, wenn eine Charge-Balance Architektur angewendet wird. Diese dritte Architektur für ein Sensorinterface ist eine Kombination aus der Open-Loop Architektur und der Force-Feedback Architektur. Dabei wird ein Feedback an den Sensor zurückgeleitet, um eine an dem Sensor anliegende Spannung einzustellen, wobei diese Spannung nicht dazu verwendet wird, um eine Bewegung der Schwungmasse zu verhindern.

Aus der Arbeit von J. B. Vladimir P. Petkov, Ganesh K. Balachandran "A fully differential charge-balanced accelerometer for electronic stability control", IEEE Journal of Solid-State Circuits, vol. 49, no. 1, pp. 262-270, January 2014, ist eine Sensorarchitektur bekannt, welche auf einer Charge-Balance Architektur basiert. Dabei wird eine Spannung, welche auf beiden Seiten einer kapazitiven Brücke des Sensors angelegt wird, durch eine negative Feedback-Schleife bereitgestellt. Eine eingangsseitige Schaltung umfasst dabei eine Eingangsverstärkerstufe zum Verstärken und Integrieren eines ersten Signals. Ferner umfasst diese Schaltung zwei summierende Verstärker, welche die Feedback-Spannung an dem Sensor bereitstellen. Zudem umfasst diese Architektur einen Sigma-Delta-Modulator, um ein zweites Signal in einen Bitstream umzusetzen, der durch einen ausgangsseitigen Schaltkreis verarbeitet wird.

Die Dissertation von C. D. Ezekwe, "Readout techniques for high-q micromachined vibratory rate gyroscopes", Ph.D. dissertation, University of California, Berkeley, 2007 offenbart eine Schaltung zum Betreiben eines kapazitiven Sensors, welche als geschlossene Schleife implementiert ist, um ein kapazitives MEMS-Gyroskop zu betreiben. Die Schaltung umfasst dabei eine GM-Stufe, welche dazu geeignet ist ein Sensorsignal zu konvertieren und zu verstärken. Die Schaltung umfasst ferner einen Analog zu Digital Wandler, welcher dazu geeignet ist, das Sensorsignal zu digitalisieren.

Die EP 2428774 B1 offenbart einen elektrischen Schaltkreis zum Messen eines kapazitiven Wertes eines MEMS-Sensors. Dabei wird unter anderem ein Boxcar-Sampling angewendet. Die EP0718631A2 offenbart einen kapazitiven Beschleunigungsaufnehmer mit elektrostatischem Servosystem, welcher eine Hold-schaltung umfasst.

Der Technische Bericht "Readout Techniques for High-Q Micromachined Vibratory Rate Gyroscopes" von Chinwuba David Ezekwe, XP007911506, offenbart ein Abtasten eines Sensors mittels eines Boxcar-Abtasters.

### Offenbarung der Erfindung

Die erfindungsgemäße Schaltung zum Betreiben eines kapazitiven Sensors ist dazu eingerichtet, wechselweise über ein erstes Zeitintervall in einem ersten Modus und über ein zweites Zeitintervall in einem zweiten Modus betrieben zu werden. Die Schaltung umfasst eine GM-Stufe, einen Integrierer und eine Hold-Schaltung. Die GM-Stufe weist einen ersten Eingangskontakt und einen zweiten Eingangskontakt auf und ist dazu eingerichtet, an dem ersten Eingangskontakt der GM-Stufe eine Sensorspannung des kapazitiven Sensors zu empfangen und die Sensorspannung in einen Sensorstrom umzusetzen, um in dem zweiten Zeitintervall eine erste Boxing-Kapazität durch den Sensorstrom zu laden. Der Integrierer ist dazu eingerichtet, in dem zweiten Zeitintervall eine über die erste Boxing-Kapazität anliegende Spannung über deren zeitigen Verlauf hinweg zu integrieren und an einem Ausgang des Integrierers eine daraus resultierende Ausgangsspannung auszugeben. Die Hold-Spannung ist dazu eingerichtet, in dem zweiten Zeitintervall die Ausgangsspannung des Integrierers abzugreifen und an einem Ausgang der Hold-Schaltung als Hold-Spannung zu halten. Die Schaltung ist ferner dazu eingerichtet, in dem ersten und in dem zweiten Zeitintervall die Hold-Spannung dem kapazitiven Sensor als Feedback-Spannung und einem Analog-Digital-Wandler als zu wandelnde Eingangsspannung bereitzustellen, und die erste Boxing-Kapazität in dem ersten Zeitintervall zu entladen. Die Schaltung ist dazu eingerichtet, den zweiten Eingangskontakt der GM-Stufe in dem zweiten Zeitintervall in einen floatenden Zustand zu schalten oder in dem zweiten Zeitintervall über eine Massekapazität mit einer Schaltungsmasse zu koppeln.

Die Schaltung zum Betreiben des kapazitiven Sensors ist dazu eingerichtet, wechselweise über ein erstes Zeitintervall in einem ersten Modus und über ein zweites Zeitintervall in einem zweiten Modus betrieben zu werden. Das bedeutet, dass wechselweise entweder der erste oder der zweite Modus vorliegt. Optional liegt zwischen dem ersten Zeitintervall und dem zweiten Zeitintervall ein weiteres Zeitintervall. Die Schaltung kann somit sowohl mit zumindest 2 oder zumindest 3 Phasen genutzt werden.

Die GM-Stufe ist ein Schaltkreis, welcher dazu geeignet ist, eine Eingangsspannung, welche an den Eingangskontakten der GM-Stufe anliegt, in einen Strom umzusetzen. Daher wird durch die GM-Stufe eine Sensorspannung des kapazitiven Sensors empfangen und in einen Sensorstrom umgesetzt. Dies erfolgt bevorzugt mittels eines Transkonduktanzverstärkers, dessen Eingänge mit den Eingangskontakten gekoppelt sind. Durch den von der GM-Stufe bereitgestellten Sensorstrom wird eine Boxing-Kapazität geladen. Die Boxing-Kapazität ist dabei bevorzugt von der GM-Stufe umfasst. Alternativ ist die Boxing-Kapazität eine Kapazität, welche mit einem Ausgang der GM-Stufe gekoppelt ist. So ist die Boxing-Kapazität insbesondere eine Kapazität des Integrierers.

Der Integrierer ist dazu eingerichtet, die über die Boxing-Kapazität anliegende Spannung über deren zeitlichen Verlauf hinweg zu integrieren. Dabei erfolgt das Integrieren in dem zweiten Zeitintervall. Insbesondere erfolgt das Integrieren über mehrere, insbesondere alle aufeinander folgenden zweiten Zeitintervalle hinweg. Bevorzugt ist der Integrierer dazu eingerichtet, in dem ersten Zeitintervall einen Integrationswert zu halten, um den Integrationsvorgang in dem folgenden zweiten Zeitintervall fortzusetzen. Der Integrierer ist somit bevorzugt dazu eingerichtet, die über die erste Boxing-Kapazität anliegende Spannung über alle zweiten Zeitintervalle hinweg zu integrieren, in denen die Schaltung betrieben wird.

Die Hold-Schaltung ist dazu eingerichtet, in dem zweiten Zeitintervall die Ausgangsspannung des Integrierers abzugreifen und an einem Ausgang als Hold-Spannung zu halten. Die Hold-Schaltung wird dabei bevorzugt zurückgesetzt, bevor diese die Ausgangsspannung des Integrierers abgreift. Dies erfolgt optional in dem ersten Zeitintervall oder in dem zweiten Zeitintervall, wobei dafür nur ein Teil des ersten oder des zweiten Zeitintervalls benötigt wird. So wird die Hold-Schaltung bevorzugt am Ende des ersten Zeitintervalls oder zu Anfang des zweiten Zeitintervalls zurückgesetzt. Bevorzugt ist die Hold-Schaltung dazu eingerichtet, in dem ersten Zeitintervall und in dem zweiten Intervall die Ausgangsspannung des Integrierers zu halten, wobei die Ausgangsspannung des Integrierers, abgesehen von einem Zeitintervall in dem die Hold-Schaltung zurückgesetzt wird, bevorzugt über das gesamte erste Zeitintervall und das gesamte zweite Zeitintervall gehalten wird.

Die Schaltung ist dazu eingerichtet, in dem ersten und/oder in dem zweiten Zeitintervall die Hold-Spannung dem kapazitiven Sensor als Feedback-Spannung bereitzustellen. Dabei wird die Hold-Spannung bevorzugt über einen FeedbaccKanal zu den Eingängen des kapazitiven Sensors zurückgeführt, an denen auch eine Betriebsspannung des kapazitiven Sensors anliegt, um einen negativen Feedbackkanal zu schaffen. Die Betriebsspannung des kapazitiven Sensors ist dabei typischerweise eine Referenzspannung, welche für einen Betrieb des kapazitiven Sensors an dessen Sensoreingänge angelegt wird.

Die Hold-Spannung wird einem Analog-Digital-Wandler, insbesondere einem Delta-Sigma-Wandler, bereitgestellt, welcher die Hold-Spannung in ein digitales Ausgangssignal wandelt, welches als Messwert des kapazitiven Sensors bereitgestellt wird. Der Analog-Digital-Wandler ist optional Teil der Schaltung. Alternativ ist der Analog-Digital-Wandler eine separate bauliche Einheit, die mit der Schaltung gekoppelt ist.

Die Schaltung ist dazu eingerichtet, die erste Boxing-Kapazität in dem ersten Zeitintervall zu entladen. Das bedeutet mit anderen Worten, dass in dem ersten Zeitintervall eine Mittelwertbildung, welche durch die Boxing-Kapazität erfolgt, unterbrochen ist und zurückgesetzt wird. Dadurch, dass die Boxing-Kapazität über das zweite Zeitintervall hinweg geladen wird, erfolgt eine Mittelwertbildung, da Schwankungen in der Sensorspannung, welche auf Störeinflüssen basieren, sich bei einem Aufladen der ersten Boxing-Kapazität durch den Sensorstrom über deren zeitlichen Verlauf hinweg gegenseitig kompensieren. Lediglich eine Verschiebung eines Offsets des Sensorstroms zwischen zwei zweiten Zeitintervallen führt dazu, dass eine während der zweiten Zeitintervalle in der ersten Boxing-Kapazität kumulierte Ladung unterschiedlich ist. Somit wird durch die durch die erste Boxing-Kapazität ermöglichte Mittelwertbildung ein Rauschen aus dem Ausgangssignal des Sensors entfernt und liegt nicht am Eingang des Analog-Digital-Wandlers an.

Die Sensorspannung des kapazitiven Sensors liegt insbesondere ausschließlich an dem ersten Eingangskontakt der GM-Stufe an. Das bedeutet im Umkehrschluss, dass an dem zweiten Eingangskontakt der GM-Stufe keine Sensorspannung des kapazitiven Sensors, insbesondere irgendeines kapazitiven Sensors, anliegt.

Die Sensorspannung ist eine Spannung, welche sich an einem Ausgangskontakt des kapazitiven Sensors ergibt und eine Spannungsdifferenz zu einem Massepotential beschreibt. So ist der kapazitive Sensor und die Schaltung zum Betreiben des kapazitiven Sensors bevorzugt auf ein gemeinsames Massepotential gelegt.

Es wird somit eine besonders kompakte Schaltung und in Kombination mit dem kapazitiven Sensor eine besonders kompakte Sensorvorrichtung geschaffen. Die Sensorvorrichtung umfasst dabei die erfindungsgemäße Schaltung und den kapazitiven Sensor, wobei der kapazitive Sensor insbesondere zwei kapazitive Elemente umfasst, die zu einer Brücke verschaltet sind und ein gemeinsames Potential der kapazitiven Elemente mit dem ersten Eingangskontakt der GM-Stufe gekoppelt ist und die außenliegenden Kontakte der Brücke mit dem Ausgang der Hold-Schaltung gekoppelt sind, um mit der Hold-Spannung beaufschlagt zu werden.

Zudem wird eine Schaltung mit geringer Rauschempfindlichkeit geschaffen, welche zudem die Vorteile einer Charge-Balance Architektur aufweist. Dabei ist es ein Vorteil des auf der Charge-Balance Architektur basierten Schaltungsaufbaus gegenüber einer auf einer Closed-Loop Architektur basierenden Schaltung, dass eine geringere Schaltungskomplexität bei geringerem Energieverbrauch erreicht wird, wobei es ferner ein Vorteil gegenüber einer Open-Loop Architektur basierten Schaltung ist, dass eine höhere Linearität erzielt wird. Das verbesserte Rauschverhalten wird durch den Einsatz der GM-Stufe an einer Eingangsseite der Schaltung erreicht, welche zudem eine Verstärkerstufe ist. Insbesondere kommt dabei ein Single-Core Sensor in Kombination mit der Schaltung zum Betreiben des kapazitiven Sensors zum Einsatz, wodurch eine benötigte Fläche zur Implementierung der Sensorvorrichtung verringert wird.

Die erfindungsgemäße Schaltung ermöglicht somit eine hohe Linearität, Stabilität gegenüber Vibrationen und elektromagnetischen Einflüssen, ein niedriges Ausgangsrauschen und eine geringe Baufläche. Der kapazitive Sensor ist insbesondere ein Single-Core Sensor, also ein kapazitiver Sensor mit einer einzelnen Schwungmasse. Dabei wird erfindungsgemäß ein Boxcar-Sampling durch die GM-Stufe implementiert, um ein Rauschen in dem auf einem Charge-Balance Prinzip beruhenden Sensoraufbau zu verringern. Bevorzugt ist die Schaltung auf einer möglichst kleinen Schaltungsfläche implementiert, wobei bevorzugt die aus dem Automotive-Bereich resultierenden Anforderungen erfüllt sind. Die Sensorvorrichtung ist somit insbesondere eine Sensorvorrichtung für den automobilen Einsatz.

Dadurch, dass die Schaltung dazu eingerichtet ist, den zweiten Eingangskontakt der GM-Stufe in dem zweiten Zeitintervall in einen floatenden Zustand zu schalten oder dazu eingerichtet, den zweiten Eingangskontakt der GM-Stufe in dem zweiten Zeitintervall über eine Massekapazität mit einer Schaltungsmasse zu koppeln wird ermöglicht, dass in dem zweiten Zeitintervall durch einen nicht differentiellen Sensor ein Eingangssignal für eine differentielle Schaltung bereitgestellt wird. Bevorzugt ist der zweite Eingangskontakt der GM-Stufe auch in dem ersten Zeitintervall über die Massekapazität mit der Schaltungsmasse gekoppelt. Auf diese Weise wird sichergestellt, dass die Sensorspannung von der GM-Stufe empfangen werden kann. Insbesondere wird eine hinreichende Amplitude der Sensorspannung gewährleistet.

Die Schaltung ist dazu eingerichtet ist, den zweiten Eingangskontakt der GM-Stufe in dem ersten Zeitintervall mit dem Ausgang der Hold-Schaltung zu koppeln. Dabei wird bevorzugt an den zweiten Eingangskontakt eine gleiche Spannung angelegt wie auch an den ersten Eingangskontakt in dem ersten Zeitintervall. Es wird somit ein Eingangssignal, welches über die Eingangskontakte der GM-Stufe anliegt, also ein Spannungsabfall zwischen dem ersten Eingangskontakt und dem zweiten Eingangskontakt der GM-Stufe, minimiert. So wird insbesondere auch der erste Eingangskontakt der GM-Stufe in dem ersten Zeitintervall mit dem Ausgang der Hold-Schaltung gekoppelt, um eine minimale Spannungsdifferenz zwischen den Eingangskontakten der GM-Stufe zu erreichen. Gleichzeitig wird dabei sichergestellt, dass eine in dem kapazitiven Sensor vorliegende Ladung erhalten bleibt, da der erste Eingangskontakt nicht auf ein Nullpotential oder ein Massepotential gelegt wird.

Die Unteransprüche zeigen bevorzugte Weiterbildungen der Erfindung.

Bevorzugt ist die GM-Stufe, der Integrierer und die Hold-Schaltung jeweils einer differentiellen Schaltung. Das bedeutet, dass die GM-Stufe, der Integrierer und die Hold-Schaltung jeweils zwei Eingangskontakte und zwei Ausgangskontakte aufweisen. Dabei sind die an den beiden den Ausgangskontakten anliegenden Spannungen bevorzugt beide auf eine zugehörige Masse der Schaltung bezogen sind. Es wird somit durch die erfindungsgemäße Schaltung ermöglicht, dass ein einzelner kapazitiver Sensor, welcher kein differentielles Ausgangssignal bereitstellt, einer Signalverarbeitung durch die Schaltung unterzogen wird, bei welcher die Vorteile einer differentiellen Schaltung genutzt werden.

Bevorzugt umfasst die GM-Stufe ferner einen Chopping-Circuit, welcher dazu eingerichtet ist, den Sensorstrom in einem ersten Chopping-Zeitintervall an die erste Boxing-Kapazität und in einem zweiten Chopping-Zeitintervall an eine zweite Boxing-Kapazität zu leiten, um die Boxing-Kapazitäten in dem zweiten Zeitintervall des jeweiligen Chopping-Zeitintervalls durch den Sensorstrom zu laden. Dabei ist der Chopping-Circuit bevorzugt auch dazu eingerichtet ist, einen Sensorstrom in dem ersten Chopping-Zeitintervall an die zweite Boxing-Kapazität und in einem zweiten Chopping-Zeitintervall an die erste Boxing-Kapazität zu leiten, um die Boxing-Kapazitäten in dem zweiten Zeitintervall des jeweiligen Chopping-Zeitintervalls durch den Sensorstrom zu laden. Die Sensorströme werden dabei bevorzugt an unterschiedlichen Ausgängen eines differentiellen Verstärkers bereitgestellt. Die erste Boxing-Kapazität und die zweite Boxing-Kapazität sind dabei insbesondere auf unterschiedlichen Pfaden der differentiellen GM-Stufe oder des differentiellen Integrierers angeordnet. So ist die GM-Stufe bevorzugt dazu eingerichtet, die erste Boxing-Kapazität in dem ersten Chopping-Zeitintervall mit dem ersten Eingangskontakt zu koppeln. Des Weiteren ist die GM-Stufe bevorzugt dazu eingerichtet, die zweite Boxing-Kapazität in dem zweiten Chopping-Zeitintervall mit dem ersten Eingangskontakt zu koppeln. Dabei wird bevorzugt in dem ersten Chopping-Zeitintervall die zweite Boxing-Kapazität über einen zweiten Verstärkerausgang eines Verstärkers der GM-Stufe mit dem zweiten Eingangskontakt gekoppelt und in dem zweiten Chopping-Intervall die erste Boxing-Kapazität über einen ersten Verstärkerausgang des Verstärkers der GM-Stufe mit dem zweiten Eingangskontakt gekoppelt. Der Chopping-Circuit ist insbesondere ein Kreuzschalter oder eine Schaltung, durch welche die Funktion eines Kreuzschalters realisiert ist, welcher die beiden differentiellen Pfade der GM-Stufe verbindet. Der Chopping-Circuit ist eine Schaltung, welche den ersten Eingangskontakt und den zweiten Eingangskontakt der GM-Stufe beziehungsweise die Ausgänge eines Verstärkers der GM-Stufe wechselweise mit unterschiedlichen differentiellen Pfaden der differentiellen GM-Stufe koppelt. Bevorzugt arbeitet der Chopping-Circuit in dem ersten Zeitintervall in entsprechender Weise wie auch in dem zweiten Zeitintervall. So liegt sowohl in dem ersten Chopping-Zeitintervall als auch in dem zweiten Chopping-Zeitintervall jeweils ein erstes Zeitintervall und ein zweites Zeitintervall vor. Es wird somit
erreicht, dass das von dem Sensor bereitgestellte Signal, also die Sensorspannung und der daraus resultierende Sensorstrom, in beiden differentiellen Pfaden der Schaltung bereitsteht. Betrachtet man ein differentielles Signal der GM-Stufe, so wird dabei eine Polarität des differentiellen Signals mit dem Chopping-Zeitintervall gewechselt.

Auch ist es vorteilhaft, wenn die Schaltung dazu eingerichtet ist, den zweiten Eingangskontakt der GM-Stufe in dem ersten Zeitintervall des ersten Chopping-Zeitintervalls derart über einen Feedbackpfad mit dem Ausgang der Hold-Schaltung zu koppeln, dass an diesem eine Spannung anliegt, die sich aus einer Common-Mode-Spannung zuzüglich der halben Hold-Spannung ergibt, und den zweiten Eingangskontakt der GM-Stufe in dem ersten Zeitintervall des zweiten Chopping-Zeitintervalls derart über einen Feedbackpfad mit dem Ausgang der Hold-Spannung zu koppeln, dass an diesem eine Spannung anliegt, die sich aus der Common-Mode-Spannung abzüglich der halben Hold-Spannung ergibt. Die Common-Mode-Spannung ist dabei eine Spannung, die an einem Common-Mode-Potential der Schaltung anliegt und eine Common-Mode-Spannung der differentiellen Bauelemente ist. Die halbe Hold-Spannung ist dabei insbesondere eine Spannung, welche zwischen dem Common-Mode-Potential und einem Ausgangskontakt der Hold-Schaltung, insbesondere der differentiellen Hold-Schaltung anliegt. Insbesondere wird während dem ersten Chopping-Intervall eine Ausgangsspannung der Hold-Stufe ganz oder anteilig mit einer ersten Polarität an den ersten Eingangskontakt und den zweiten Eingangskontakt der GM-Stufe und auch an einen ersten Eingangskontakt und einen zweiten Eingangskontakt des kapazitiven Sensors angelegt. Entsprechend wird bevorzugt in einem zweiten Chopping-Zeitintervall diese Ausgangsspannung der Hold-Schaltung mit umgekehrter Polarität an die entsprechenden Eingangskontakte der GM-Stufe und des kapazitiven Sensors angelegt.

Das erste Chopping-Zeitintervall und das zweite Chopping-Zeitintervall sind entweder von gleicher zeitlicher Dauer, unterschiedlicher Dauer oder sind in ihrer Dauer zufällig gewählt. So ist der Chopping-Circuit insbesondere dazu geeignet, eine Verträglichkeit gegenüber elektromagnetischer Interferenzen in einem Breitbandspektrum zu verbessern. Ein Fs/2 Chopping, also ein Chopping mit gleichlangem ersten Chopping-Zeitintervall und zweiten Chopping-Zeitintervall, kann unter Umständen nicht ausreichend sein, da Interferenzen zurück in das Basisband gekoppelt werden, was insbesondere bei automobilen Anwendungen kritisch sein kann. Zufälliges Chopping kann daher vorteilhafterweise in einer Weise genutzt werden, sodass die Energie der Interferenzen über eine weitere Bandbreite verteilt wird, damit lediglich ein geringer Anteil der EMI-Einflüsse im Signalband erscheint. Das Chopping ist somit dazu geeignet, schmalbandiges Rauschen, wie zum Beispiel ein Flickerrauschen oder Offsetrauschen, zu entfernen. Dabei umfasst der Chopping-Circuit bevorzugt auch ein Schaltelement in dem Kopplungspfad zwischen der Hold-Schaltung und dem kapazitiven Sensor. Durch die zugehörigen Dechopping-Schalter kann die Hold-Spannung an die entsprechenden Eingangskontakte des kapazitiven Sensors mit der gewünschten Polarität geleitet werden. Der Chopping-Circuit umfasst somit bevorzugt einen zweiteiligen Schaltkreis, wobei die Polarität in einem differentiellen Pfad zweifach umgedreht wird. Es erfolgt somit ein Chopping und ein Dechopping. Die für das Dechopping benötigten Schalter können alternativ an einem Ausgang des Integrierers angeordnet sein, wodurch eine EMI-Robustheit und eine Offset-Cancellation der GM-Stufe und des Integrierers ermöglicht wird. Durch den Chopping-Circuit wird zudem vermieden, dass Ladungen innerhalb des Sensors aufgebaut werden.

Ferner ist es vorteilhaft, wenn die Schaltung eine Neutralisierungskapazität umfasst, wobei eine erste Seite der Neutralisierungskapazität mit dem ersten Eingangskontakt der GM-Stufe gekoppelt ist und eine zweite Seite der Neutralisierungskapazität dazu eingerichtet ist, wahlweise derart über einen Feedbackpfad mit dem Ausgang der Hold-Schaltung gekoppelt zu werden, dass an der zweiten Seite der Neutralisierungskapazität eine Spannung anlegt, die sich aus der Common-Mode-Spannung zuzüglich der halben Hold-Spannung ergibt oder derart über einen Feedbackpfad mit dem Ausgang der Hold-Schaltung gekoppelt zu werden, dass an der zweiten Seite der Neutralisierungskapazität eine Spannung anliegt, die sich aus der Common-Mode-Spannung abzüglich der halben Hold-Spannung ergibt. Dabei wird insbesondere in dem ersten Zeitintervall jeweils eine solche Spannung an der zweiten Seite der Neutralisierungskapazität angelegt, welche der Spannung entspricht, welche an dem zweiten Eingangskontakt der GM-Stufe angelegt ist. Durch die Neutralisierungskapazität wird eine hohe Linearität gewährleistet. Da die Kapazitäten des kapazitiven Sensors Durchführungskapazitäten beinhalten kann, deren Einfluss durch die Neutralisierungskapazität kompensiert werden. Die Neutralisierungskapazität ist optional und wird nicht benötigt, wenn der Einfluss der Durchführungskapazitäten ignoriert werden kann. Insbesondere wenn eine Neutralisierungskapazität genutzt wird, wird das Ausgangssignal der Hold-Schaltung und somit des Integrierers während dem ersten Zeitintervall und dem zweiten Zeitintervall benötigt.

Auch ist es vorteilhaft, wenn die erste Boxing-Kapazität und/oder die zweite Boxing-Kapazität eine Kapazität des Integrierers ist. Auf diese Weise wird eine besonders kompakte Schaltung geschaffen, da die Anzahl der benötigten Kapazitäten verringert wird.

Ferner ist es vorteilhaft, wenn der kapazitive Sensor ein MEMS-Sensor, insbesondere ein Beschleunigungssensor oder ein MEMS-Gyroskop ist.

### Kurze Beschreibung der Zeichnungen

Nachfolgend werden Ausführungsbeispiele der Erfindung unter Bezugnahme auf die begleitende Zeichnung im Detail beschrieben. In der Zeichnung ist:
- Figur 1: ein Blockschaltbild einer erfindungsgemäßen Sensorvorrichtung, welche eine erfindungsgemäße Schaltung umfasst,
- Figur 2: eine Sensorvorrichtung, welche eine Schaltung zum Betreiben eines kapazitiven Sensors gemäß einer ersten Ausführungsform der Erfindung umfasst, und
- Figur 3: eine Sensorvorrichtung, welche eine Schaltung zum Betreiben eines kapazitiven Sensors gemäß einer zweiten Ausführungsform der Erfindung umfasst.

### Ausführungsformen der Erfindung

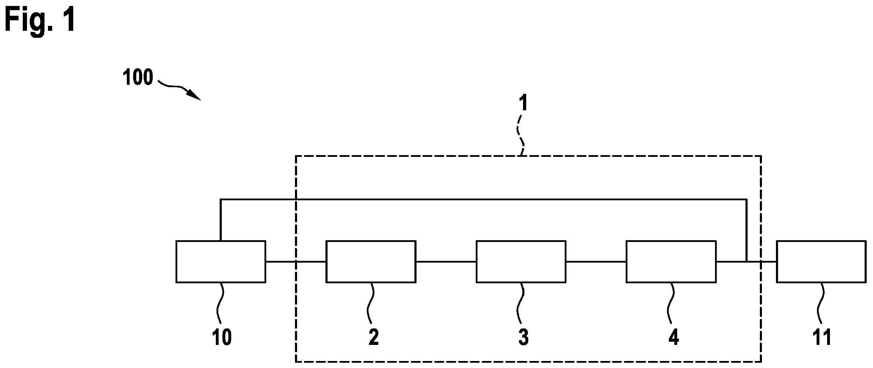

Figur 1 zeigt ein Blockschaltbild einer Sensorvorrichtung 100. Die Sensorvorrichtung 100 umfasst eine Schaltung 1 zum Betreiben eines kapazitiven Sensors 10. Der kapazitive Sensor 10 ist dabei ein MEMS-Sensor, insbesondere ein Beschleunigungssensor oder ein MEMS-Gyroskop. Der MEMS-Sensor 11 ist insbesondere ein Single-Core Sensor. Die Schaltung 1 ist somit eine Schaltung zum Betreiben eines MEMS-Sensors.

Der Sensor 10 weist eine Eingangsseite und eine Ausgangsseite auf. Die Ausgangsseite des kapazitiven Sensors 10 ist mit einer GM-Stufe 2 gekoppelt. Von dieser wird ein Ausgangssignal, hier eine Sensorspannung, des kapazitiven Sensors 10 in einen Sensorstrom umgesetzt und ein Boxcar-Sampling ausgeführt. Eine Ausgangsseite der GM-Stufe 2 ist mit einem Integrierer 3 gekoppelt. Eine Ausgangsseite des Integrierers 3 ist mit einer Eingangsseite einer Hold-Schaltung 4 gekoppelt.

Durch den Integrierer 3 erfolgt ein Integrieren über einen zeitlichen Verlauf eines Ladungszustandes einer Boxing-Kapazität, welche durch den Sensorstrom der GM-Stufe 2 geladen wird. Die daraus resultierende Ausgangsspannung des Integrierers 3 wird von der Hold-Schaltung 4 abgetastet, gehalten und an einer Ausgangsseite der Hold-Schaltung 4 als Hold-Spannung bereitgestellt. Die Hold-Spannung wird dem kapazitiven Sensor 10 als Feedback-Spannung bereitstellt. Ferner ist ein Analog-Digital-Wandler 11, bevorzugt einem Sigma-Delta-Wandler, mit der Ausgangsseite der Hold-Schaltung 4 gekoppelt. Dem Analog-Digital-Wandler 11 wird somit die Hold-Spannung als zu wandelnde Eingangsspannung bereitgestellt. Alternativ kann der Ausgang des Integrators als zu wandelnde Eingangsspannung dem Analog-Digital-Wandler 11 bereitgestellt werde.

Dadurch, dass die Hold-Schaltung 4 das Ausgangssignal des Integrierers hält, ergibt sich die Möglichkeit, dass die Boxing-Kapazität, welche für das Boxcar-Sampling benötigt wird, zurückgesetzt werden kann und zugleich ein Ladungszustand der Kapazitäten des kapazitiven Sensors 10 erhalten werden kann. Es wird somit eine Sensorvorrichtung geschaffen, welche einen Ladungsausgleich des kapazitiven Sensors 10 sicherstellt. Eine solche Schaltung, wie diese auch in Figur 1 gezeigt ist, wird auch als Charge-Balance Sensor bezeichnet.

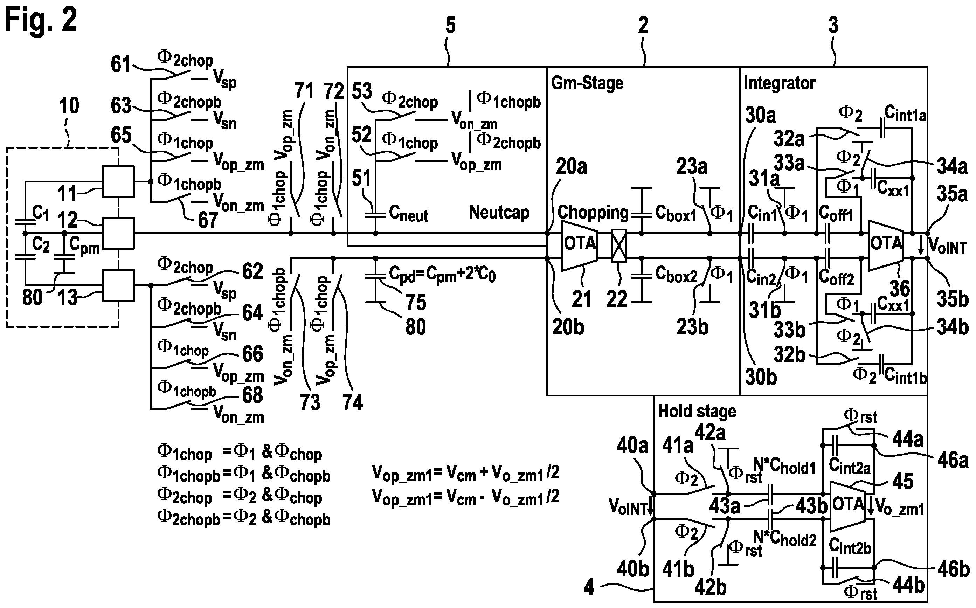

Figur 2 zeigt eine erste Ausführungsform der Erfindung, wobei die in Figur 2 gezeigte Schaltung dem in Figur 1 gezeigten Aufbau aufweist.

Der kapazitive Sensor 10 weist eine erste Kapazität C1 und eine zweite Kapazität C2 auf. Die erste Kapazität und die zweite Kapazität C1, C2 sind die kapazitiven Elemente des kapazitiven Sensors 10. Dabei sind die kapazitiven Elemente insbesondere jeweils ein Kondensator, der aus einer Schwungmasse und jeweils einer weiteren Elektrode des kapazitiven Sensors 10 gebildet wird. Die erste Kapazität C1 und die zweite Kapazität C2 sind zu einer Brücke verschaltet. Dazu ist ein Kontakt der ersten Kapazität C1 mit einem Kontakt der zweiten Kapazität C2 gekoppelt, wodurch dieser gemeinsame Kontakt ein gemeinsames Potential 12 aufweist, wobei der gemeinsame Kontakt zugleich ein Ausgangsanschluss 12 des kapazitiven Sensor 10 ist, an welchem eine Sensorspannung des kapazitiven Sensors 10 bereitgestellt wird. Die Kontakte der ersten Kapazität C1 und der zweiten Kapazität C2, welche nicht miteinander verbunden sind, bilden zwei Eingangsanschlüsse 11, 13 des kapazitiven Sensors 10. So ist ein erster Sensoreingang 11 über die erste Kapazität C1 mit dem Sensorausgang 12 gekoppelt. Ferner ist ein zweiter Sensoreingang 13 über die zweite Kapazität C2 mit dem Sensorausgang 12 gekoppelt. Optional weist der kapazitive Sensor 11 eine Erdungskapazität Cpm auf, welche das gemeinsame Potential 12 mit einer Schaltungsmasse 80 der Sensorvorrichtung 100 verbindet. Die Erdungskapazität Cpm kann dabei eine parasitäre Kapazität sein.

Das gemeinsame Potential und somit der Sensorausgang 12 ist mit einem ersten Eingangskontakt 20a der GM-Stufe 2 gekoppelt. Die Sensoreingänge 11, 12 des kapazitiven Sensors 10 sind mit einem Ausgang 46a, 46b der Hold-Schaltung 4 gekoppelt, um mit einer Hold-Spannung Vo_zm beaufschlagt zu werden, welche durch die Hold-Schaltung 4 an deren Ausgang 46a, 46b gehalten wird. Dies erfolgt über eine Vielzahl von Feedback-Schaltern 61 bis 68, welche es erlauben unterschiedliche Spannungen an den ersten Sensoreingang 11 und den zweiten Sensoreingang 13 anzulegen. So ist der erste Sensoreingang 61 mit jeweils einer ersten Seite eines ersten Feedback-Schalters 61, eines dritten Feedback-Schalters 63, eines fünften Feedback-Schalters 65 und eines siebten Feedback-Schalters 67 gekoppelt. In entsprechender Weise ist der zweite Sensoreingang 13 mit einer zweiten Seite eines zweiten Feedback-Schalters 62, eines vierten Feedback-Schalters 64, eines sechsten Feedback-Schalters 66 und eines achten Feedback-Schalters 68 gekoppelt. Die zweite Seite der Feedback-Schalter ist jeweils über einen Feedbackpfad mit dem Ausgang 46a, 46b der Hold-Schaltung 4 und/oder einer eine Referenzspannung erzeugenden Spannungsquellte gekoppelt.

Der Sensorausgang 12 ist mit einem ersten Eingangskontakt 20a der GM-Stufe 2 verbunden. Ferner ist der Sensorausgang 12 mit einem ersten Eingangspotentialschalter 71 und einem Eingangspotentialschalter 72 verbunden, durch welche der Sensorausgang 12 mit einem Ausgang der Hold-Schaltung 4 gekoppelt werden kann. Dazu ist der Sensorausgang 12 über einen in Figur 2 nicht gezeigten Feedbackpfad mit dem Ausgang der Hold-Schaltung 4 gekoppelt. Ein zweiter Eingangskontakt 20b der GM-Stufe 2 ist über eine zweite Massekapazität 75 mit der Schaltungsmasse gekoppelt. Ferner ist der zweite Eingangskontakt 20b der GM-Stufe 2 über einen dritten Eingangspotentialschalter 73 und einen vierten Eingangspotentialschalter 74 über einen Feedbackpfad mit dem Ausgang 46a, 46b der Hold-Schaltung 4 gekoppelt. Durch die Eingangspotentialschalter 71 bis 74 wird ein Potential der Eingangskontakte 20a, 20b der GM-Stufe 2 mit einem Feedbackpfad verbunden, welcher durch die Hold-Schaltung 4 versorgt wird.

Die GM-Stufe 2, der Integrierer 3 und die Hold-Schaltung 4 sind in dieser ersten Ausführungsform differentielle Schaltungen. Diese differentiellen Schaltungen weisen einen differentialen Signalpfad auf, also einen zweigeteilten Signalpfad. Diese beiden Pfade werden im Folgenden als erster differentieller Signalpfad und zweiter differentieller Signalpfad bezeichnet. Der erste differentielle Signalpfad und der zweite differentielle Signalpfad sind in der GM-Stufe 2, dem Integrierer 3 und der Hold-Schaltung 4 symmetrisch zueinander aufgebaut, weisen also gleiche Komponenten in gleicher Verschaltung auf.

Die GM-Stufe 2 weist einen ersten Verstärker 21 auf, welcher ein differentieller Transkonduktanzverstärker ist. Ein erster Eingang des ersten Verstärkers 21 ist mit dem ersten Eingangskontakt 20a verbunden oder bildet diesen ersten Eingangskontakt 20a. Ein zweiter Eingang des ersten Verstärkers 21 ist mit dem zweiten Eingangskontakt 20b der GM-Stufe 2 verbunden oder bildet diesen zweiten Eingangskontakt 20b. Die GM-Stufe 2 umfasst ferner eine erste Boxing-Kapazität Cbox1 und eine zweite Boxing-Kapazität Cbox2. Dabei ist ein Anschluss der ersten Boxing-Kapazitäten Cbox1 mit einem zugehörigen ersten Ausgang eines Chopping-Circuits 22 verbunden und ein Anschluss der zweiten Boxing-Kapazitäten Cbox2 mit einem zugehörigen zweiten Ausgang des Chopping-Circuits 22 verbunden. Die beiden Eingänge des Chopping-Circuits 22 sind mit jeweils einem Ausgang des ersten Verstärkers 21 verbunden. Die Anschlüsse der Boxing-Kapazitäten Cbox1, Cbox2, welche nicht mit dem Chopping-Circuit 22 verbunden sind, sind mit der Schaltungsmasse 80 verbunden.

Wird durch den kapazitiven Sensor 10 über dessen Sensorausgang 12 eine Sensorspannung bereitgestellt, so liegt diese an dem ersten Eingangskontakt 20a der GM-Stufe 2 an und wird von dem ersten Verstärker 21 in einen Sensorstrom umgesetzt. Abhängig von einem Schaltungszustand des Chopping-Circuits 22 wird dieser Sensorstrom in die erste Boxing-Kapazität Cbox1 oder in die zweite Boxing-Kapazität Cbox2 geleitet.

Die Schaltung 1 zum Betreiben des kapazitiven Sensors 10 ist dazu eingerichtet, wechselweise über ein erstes Zeitintervall Φ1 in einem ersten Modus und über ein zweites Zeitintervall Φ2 in einen zweiten Modus betrieben zu werden. Dabei wird die Schaltung 1 in dieser ersten Ausführungsform ausschließlich entweder in dem ersten Modus oder in dem zweiten Modus betrieben. Das bedeutet, dass zu jedem Zeitpunkt entweder das erste Zeitintervall Φ1 oder das zweite Zeitintervall Φ2 vorliegt. Der erste Modus und der zweite Modus unterscheiden sich darin, dass eine Vielzahl von Schaltelementen in der Sensorvorrichtung 100 in einen entsprechenden Schaltzustand gebracht werden. Dies ist in Figur 1 derart dargestellt, dass die Schaltelemente, welche als Φ1 markiert sind, in dem ersten Zeitintervall Φ1 in einen geschlossenen Zustand gebracht werden. In entsprechender Weise werden die Schaltelemente, welche als Φ2 Elemente bezeichnet sind, in dem zweiten Zeitintervall Φ2 in einen geschlossenen Zustand gebracht.

Ferner wird die Schaltung 1 wechselweise in einem ersten Chopping-Zeitintervall chop und einem zweiten Chopping-Zeitintervall chopb betrieben. Sowohl das erste Chopping-Zeitintervall chop als auch das zweite Chopping-Zeitintervall chopb ist in jeweils ein erstes Zeitintervall Φ1 und in ein zweites Zeitintervall Φ2 unterteilt. So setzt sich das erste Chopping-Zeitintervall chop aus einem ersten Zeitintervall Φ1und einem zweiten Zeitintervall Φ2zusammen. In entsprechender Weise setzt sich auch das zweite Chopping-Zeitintervall chopb aus einem ersten Zeitintervall Φ1und einem zweiten Zeitintervall Φ2zusammen. Dies bedeutet, dass bei der in Figur 1 gezeigten Darstellung solche der Schaltelemente, welche mit dem Index "chop" gekennzeichnet sind, in dem jeweils angezeigten ersten oder zweiten Zeitintervall Φ1, Φ2 nur während des ersten Chopping-Zeitintervalls chop in einen geschlossenen Zustand geschalten werden. In entsprechender Weise bedeutet dies ferner, dass die Schaltelemente, welche mit dem Index "chopb" gekennzeichnet sind, in dem jeweils angezeigten ersten oder zweiten Zeitintervall Φ1, Φ2 nur während des zweiten Chopping-Zeitintervalls chopb in einen geschlossenen Zustand geschalten werden. Ist weder ein Index chop oder chopb gezeigt, so wird das jeweilige Schaltelement unabhängig von dem vorliegenden Chopping-Zeitintervall in einen geschlossenen Zustand geschaltet. Ob das erste Chopping-Zeitintervall chop oder das zweite Chopping-Zeitintervall chopb vorliegt, ist abhängig von einem Schaltzustand eines Chopping-Circuits 22.

Die GM-Stufe 2 wird derart angesteuert, dass in dem ersten Chopping-Zeitintervall chop ein erster Ausgang des ersten Verstärkers 21 mit der ersten Boxing-Kapazität Cbox1 verbunden ist und ein zweiter Ausgang des ersten Verstärkers 21 mit der zweiten Boxing-Kapazität Cbox2 verbunden ist. In dem zweiten Chopping-Zeitintervall chopb ist der erste Ausgang des ersten Verstärkers 21 mit der zweiten Boxing-Kapazität Cbox2 verbunden und der zweite Ausgang des ersten Verstärkers 21 ist mit der ersten Boxing-Kapazität Cbox1 verbunden. Es werden somit in dem zweiten Zeitintervall Φ2 abhängig von dem vorliegenden Chopping Zeitintervall die erste Boxing-Kapazität Cbox1 und die zweite Boxing-Kapazität Cbox2 mit wechselnd mit den unterschiedlichen Ausgängen des Verstärkers verbunden und somit wird jeweils eine der Boxing-Kapazitäten durch den Sensorstrom, welcher an dem ersten Ausgang von dem ersten Verstärker 21 bereitgestellt wird, aufgeladen.

Betrachtet man den Sensorstrom als den Strom, der an dem ersten Ausgang des ersten Verstärkers 21 ausgegeben wird, so ist der Chopping-Circuit 22 dazu eingerichtet, den Sensorstrom, welcher an dem ersten Ausgang des ersten Verstärkers 21 ausgegeben wird, in dem ersten Chopping-Zeitintervall chop an die erste Boxing-Kapazität Cbox1 und in dem zweiten Chopping-Zeitintervall chopb an die zweite Boxing-Kapazität Cbox2 zu leiten, um die Boxing-Kapazitäten Cbox 1, Cbox 2 in dem ersten Zeitintervall Φ2 des jeweiligen Chopping-Zeitintervalls chop, chopb durch den Sensorstrom zu laden. Dies gilt in entsprechender Weise, falls der Sensorstrom als der Strom angesehen wird, der von dem zweiten Ausgang des ersten Verstärkers 21 ausgegeben wird. Dabei wird jedoch der Sensorstrom in dem ersten Chopping-Zeitintervall an die zweite Boxing-Kapazität Cbox2 und in dem zweiten Chopping-Zeitintervall an die erste Boxing-Kapazität Cbox1 geleitet. Es werden beide Boxing-Kapazitäten Cbox 1, Cbox 2 in dem zweiten Zeitintervall Φ2 geladen.

Die Boxing-Kapazitäten Cbox1, Cbox2 werden somit mit den beiden Chopping-Zeitintervallen chop, chopb wechselweise über die beiden Ausgänge des ersten Verstärkers 21 geladen. Wird die GM-Stufe 2 während des zweiten Zeitintervalls Φ2 in dem zweiten Modus betrieben, so werden die Boxing-Kapazitäten Cbox1, Cbox2 aufgeladen. Wird die GM-Stufe 2 in dem ersten Modus, also während des ersten Zeitintervalls Φ1, betrieben, so werden die Boxing-Kapazitäten Cbox1, Cbox2 entladen. Dazu umfasst die GM-Stufe 2 einen ersten Entladungsschalter 23a, welcher den Kontakt der ersten Boxing-Kapazität Cbox1, welcher auch mit dem Chopping-Circuit 22 verbunden ist, in dem ersten Zeitintervall Φ1auf das Massepotential 80 schaltet. Ferner umfasst die GM-Stufe 2 dazu einen zweiten Entladeschalter 23b, welcher den Kontakt der zweiten Boxing-Kapazität Cbox2, der auch mit dem Chopping-Circuit 22 verbunden ist, in dem ersten Zeitintervall Φ1auf das Massepotential 80 schaltet.

Die Boxing-Kapazität in Cbox1, Cbox2 werden somit während dem zweiten Zeitintervall Φ2 geladen und in dem ersten Zeitintervall Φ1 entladen. Dadurch, dass die Boxing-Kapazitäten Cbox1, Cbox2 über ein bestimmtes Zeitintervall hinweg aufgeladen werden, erfolgt eine Mittelung des eingehenden Sensorstroms. Dadurch wird ein in dem Sensorstrom vorliegendes Rauschen durch eine Mittelwertbildung entfernt. Es wird somit durch die GM-Stufe 2 ein Boxcar-Sampling implementiert.

Die erste Boxing-Kapazität Cbox1 ist mit einem ersten Integrierereingang 30a des Integrierers 3 verbunden. Die zweite Boxing-Kapazität Cbox2 ist mit einem zweiten Integrierereingang 30b des Integrierers 3 verbunden. Über die Integrierereingänge 30a, 30b wird eine über die Boxing-Kapazitäten Cbox1, Cbox2 anliegende Spannung über deren zeitlichen Verlauf hinweg integriert. Dies erfolgt in dem zweiten Zeitintervall Φ2. Eine daraus resultierende Ausgangsspannung Voint wird an einem Ausgang 35a, 35b, welcher einen ersten Ausgangskontakt 35a und einen zweiten Ausgangskontakt 35b umfasst, des Integrierers 3 bereitgestellt.

Der Integrierer 3 umfasst eine erste Eingangskapazität Cin1 und eine zweite Eingangskapazität Cin2. Die erste Eingangskapazität Cin1 ist mit dem ersten Integrierereingang 30a verbunden. Die zweite Eingangskapazität Cin2 ist mit dem zweiten Integrierereingang 30b verbunden. Durch diese eingangsseitigen Kapazitäten des Integrierers 3 wird die Spannung der Boxing-Kapazitäten Cbox1, Cbox2 aufgenomment und die entsprechende Ladung in der nächsten Phase auf die Integriererkapazitäten Cint1a, Cint1b übertragen. Der Integrierer 3 umfasst einen zweiten Verstärker 36, welcher ebenfalls ein Transkonduktanzverstärker ist. Der zweite Verstärker ist wie auch der erste Verstärker 21 ein differentieller Verstärker.

Ein erster Eingang des zweiten Verstärkers 36 ist mit der ersten Eingangskapazität Cin1 über eine erste Offset-Kapazität Coff1 des Integrierers 3 verbunden. Ein erster Ausgang des zweiten Verstärkers 36 ist mit dem ersten Ausgangskontakt 35a des Integrierers 3 verbunden. Ein zweiter Eingang des zweiten Verstärkers 36 ist mit der zweiten Eingangskapazität Cin2 über eine zweite Offset-Kapazität Coff2 des Integrierers 3 verbunden. Ein zweiter Ausgang des zweiten Verstärkers 36 ist mit dem zweiten Ausgangskontakt 35b des Integrierers 3 verbunden.

Die erste Eingangskapazität Cin1 und der erste Ausgangskontakt 35a des Integrierers 3 sind über einen Strompfad verbunden, in welchem ein erstes Schaltelement 32a des Integrierers und eine Integriererkapazität Cint1a angeordnet sind. Während des zweiten Zeitintervalls Φ2 wird in der ersten Integriererkapazität Cint1a eine Ladung integriert, welche sich aus der in der ersten Boxing-Kapazität Cbox1 vorliegenden Ladung ergibt. Ferner ist der erste Eingang des zweiten Verstärkers 36 über einen zweiten Strompfad mit dem ersten Ausgangskontakt 35a des Integrierers 3 verbunden, in welchem ein zweites Schaltelement 33a des Integrierers und eine erste weitere Kapazität Cxx1 angeordnet sind. Dieser zweite Strompfad wird in dem erste Zeitintervall Φ1 durch Schließen des zweiten Schaltelement 33a des Integrierers 3 aktiviert.

Die zweite Eingangskapazität Cin2 und der zweite Ausgangskontakt 35b des Integrierers 3 sind über einen Strompfad verbunden, in welchem ein weiteres erstes Schaltelement 32b des Integrierers und eine weitere Integriererkapazität Cint1b angeordnet sind. Während des zweiten Zeitintervalls Φ2 wird in der weiteren ersten Integriererkapazität Cint1b eine Ladung integriert, welche sich aus der in der zweiten Boxing-Kapazität Cbox2 vorliegenden Ladung ergibt. Ferner ist der zweite Eingang des zweiten Verstärkers 36 über einen zweiten Strompfad mit dem zweiten Ausgangskontakt 35b des Integrierers 3 verbunden, in welchem ein weiteres zweites Schaltelement 33b des Integrierers 3 und eine zweite weitere Kapazität Cxx2 angeordnet sind. Dieser zweite Strompfad wird in dem erste Zeitintervall Φ1 durch Schließen des weiteren zweiten Schaltelement 33b des Integrierers 3 aktiviert.

Durch die zwischen den Eingängen und den Ausgängen des zweiten Verstärkers 36 liegenden Strompfade mit den Integriererkapazitäten Cint1a, Cint1b und den weiteren Kapazitäten Cxx1, Cxx2 wird ermöglicht, dass in dem Integrierer 3 einen integrierter Wert auch während des ersten Zeitintervalls Φ1 erhalten wird und ein Integriervorgang über mehrere aufeinander folgende zweite Zeitintervalle Φ2 ausgeführt werden kann.

Ferner umfasst der Integrierer 3 in dem ersten differentiellen Strompfad einen ersten Masseschalter 31a und einen zweiten Masseschalter 34a. Der erste Masseschalter 31a ist dazu eingerichtet, die erste Eingangskapazität Cin1 in dem ersten Zeitintervall Φ1 zu entladen. Der zweite Masseschalter 31a ist dazu eingerichtet, ein eingangsseitiges Potential der erste weiteren Kapazität Cxx1 mit der Schaltungsmasse 80 zu koppeln. Ferner umfasst der Integrierer 3 in dem zweiten differentiellen Strompfad einen dritten Masseschalter 31b und einen vierten Masseschalter 34b. Der dritte Masseschalter 31b ist dazu eingerichtet, die zweite Eingangskapazität Cin2 in dem ersten Zeitintervall Φ1 zu entladen. Der vierte Masseschalter 34b ist dazu eingerichtet, ein eingangsseitiges Potential der zweiten weiteren Kapazität Cxx2 mit der Schaltungsmasse 80 zu koppeln.

Der Integrierer 3 ist somit dazu eingerichtet, in dem zweiten Zeitintervall Φ2 eine über die erste Boxing-Kapazität Cbox1 und die zweite Boxing-Kapazität Cbox2 anliegende Spannung über deren zeitlichen Verlauf hinweg zu integrieren und an dem Ausgang 35a, 35a des Integrierers 3 eine daraus resultierende Ausgangsspannung Voint auszugeben.

Ein erster Eingangskontakt 40a der Hold-Schaltung 4 ist mit dem ersten Ausgangskontakt 35a des Integrierers 3 verbunden. Ein zweiter Eingangskontakt 40b der Hold-Schaltung 4 ist mit dem zweiten Ausgangskontakt 35b des Integrierers 3 verbunden.

Die Hold-Schaltung 4 umfasst einen dritten Verstärker 45, welcher ein differentieller Transkonduktanzverstärker ist. Ein erster Eingang des dritten Verstärkers 45 ist mit dem ersten Eingangskontakt 40A der Hold-Schaltung 4 gekoppelt, wobei der erste Eingang des dritten Verstärkers 45 über ein erstes Schaltelement 41a der Hold-Schaltung 4 und eine erste Hold-Kapazität 43a mit dem ersten Eingangskontakt 40A der Hold-Schaltung 4 gekoppelt ist. Ein zweiter Eingang des dritten Verstärkers 45 ist über ein weiteres erstes Schaltelement 41b der Hold-Schaltung 4 und eine zweite Hold-Kapazität 43b mit dem zweiten Eingangskontakt 40b der Hold-Schaltung 4 gekoppelt. Der dritte Verstärker 45 ist dabei als Integrierer geschaltet. So ist der erste Eingang des dritten Verstärkers 45 über eine zweite Integrierkapazität Cint2a mit einem ersten Ausgang des dritten Verstärkers 45 verbunden. Entsprechend ist der zweite Eingang des dritten Verstärkers 45 über eine zweite Integrierkapazität Cint2b mit dem zweiten Ausgang des dritten Verstärkers 45 gekoppelt.

In dem ersten Zeitintervall Φ1 werden die Hold-Kapazitäten 43a, 43b durch die beiden ersten Schaltelemente 41a, 41b der Hold-Schaltung 4 von dem Ausgang 35a, 35b des Integrierers 3 getrennt. Durch die Hold-Schaltung 4 wird in dem zweiten Zeitintervall Φ2 die Ausgangsspannung Voint des Integrierers 3 abgegriffen und an einem Ausgang der Hold-Schaltung 4 als Hold-Spannung Vo_zm gehalten. Dazu werden die ersten Schaltelemente 41a, 41b in dem zweiten Zeitintervall Φ2 geschlossen, wodurch die Ausgangsspannung Voint des Integrierers 3 auch an dem Eingang des dritten Verstärkers 45 anliegt. Da dieser als Integrierer geschaltet ist und über die Hold-Kapazitäten 43a, 43b von den Eingangskontakten 40A, 40B der Hold-Schaltung 4 getrennt ist, liegt die Ausgangsspannung Voint des Integrierers 3 nach dem Schalten der ersten Schaltelemente 41a, 41b auch an dem Ausgang des dritten Verstärkers 45 als Hold-Spannung Vo_zm und somit an einem Ausgang der Hold-Schaltung 4 an. Dabei wird die Ausgangsspannung Voint des Integrierers 3 optional mit einem Verstärkungsfaktor beaufschlagt, um die Hold-Spannung Vo_zm zu generieren. Der Ausgang der Hold-Schaltung 4 umfasst einen ersten Ausgangskontakt 46a der Hold-Schaltung und einem zweiten Ausgangskontakt 46b der Hold-Schaltung 4.

Vor dem Schließen der Schaltelemente 41a, 41b in dem zweiten Zeitintervall Φ2 wird insbesondere am Ende des ersten Zeitintervalls Φ1 eine Anzahl von Rücksetzschaltern 42a, 42b, 44a, 44b in der Hold-Schaltung 4 geschaltet, um die darin befindlichen Kapazitäten zu entladen. So ist insbesondere jeweils ein erster Rücksetzschalter 44a, 44a zu jeweils einer der zweiten Integrierkapazitäten Cint2a, Cint2b parallelgeschaltet, um diese in einem Rückstellintervall zu entladen. Ferner ist bevorzugt auch ein Kontakt der Hold-Kapazitäten 43a, 43b über jeweils einen zweiten Rücksetzschalter 42a, 42b mit der Schaltungsmasse 80 gekoppelt, um die Hold-Kapazitäten 43a, 43b in dem Rückstellintervall zu entladen.

Die Hold-Schaltung 4 ist dazu eingerichtet, in dem zweiten Zeitintervall Φ2 die Ausgangsspannung Voint des Integrierers 3 abzugreifen und an einem Ausgang der Hold-Schaltung 4 als Hold-Spannung Vo_zm zu halten. Die an dem Ausgang 46a, 46b der Hold-Schaltung 4 anliegende Hold-Spannung Vo_zm wird dem Analog-Digital-Wandler 11 bereitgestellt. Dazu sind die Eingänge des Analog-Digital-Wandlers 11 bevorzugt direkt mit den Ausgangskontakten 46a, 46b der Hold-Schaltung 4 verbunden. Ferner werden zumindest in dem ersten Zeitintervall Φ1, bevorzugt in dem ersten und in dem zweiten Zeitintervall Φ1, Φ2 die Hold-Spannung Vo_zm dem kapazitiven Sensor 10 als Feedback-Spannung bereitgestellt. Dies bedeutet, dass zumindest ein Feedbackpfad zwischen dem Ausgang der Hold-Schaltung 4 und den Sensoreingängen 11, 13 des kapazitiven Sensors 10 besteht. Dabei sind in dem Feedback-Pfad auch Schaltelemente, beispielsweise die Feedbackschalter 41 bis 68, angeordnet, durch welche definiert werden kann wann und mit welcher Polarität die an dem ersten Ausgangskontakt 46A und dem zweiten Ausgangskontakt 46B der Hold-Schaltung 4 anliegenden Spannung an den kapazitiven Sensor 10 angelegt werden.

Es wird durch den ersten Ausgangsanschluss 46a der Hold-Schaltung 4 insbesondere eine erste Feedback-Spannung bereitgestellt, welche sich aus einer Spannung ergibt, die an einem Common-Mode-Potential der Schaltung 1 anliegt, auch als Common-mode Spannung bezeichnet, und der halben Hold-Spannung ergibt. So ist die erste Feedback-Spannung gleich der Common-mode-Spannung zuzüglich der halben Hold-Spannung Vo_zm. An dem zweiten Ausgangskontakt 46b der Hold-Schaltung 4 wird entsprechend eine zweite Feedback-Spannung bereitgestellt, die der Common-mode-Spannung abzüglich der halben Hold-Spannung Vo_zm entspricht.

Bei einem Betrieb der Sensorvorrichtung 100 wird in dem zweiten Zeitintervall Φ2 der zweite Eingangskontakt 20b der GM-Stufe 2 entweder in einen floatenden Zustand geschaltet oder aber, wie in Figur 1 gezeigt, über die zweite Massekapazität 75 mit der Schaltungsmasse 80 gekoppelt. Dabei ist der in Figur 1 gezeigten Ausführungsform der zweite Eingangskontakt 20b der GM-Stufe 2 durchgehend über die zweite Massekapazität 75 mit der Schaltungsmasse 80 verbunden.

In dem ersten Zeitintervall Φ1 wird der zweite Eingangskontakt 2b der GM-Stufe 2 über den Feedbackpfad mit dem Ausgang der Hold-Schaltung 4 gekoppelt. Dabei wird der zweite Eingangskontakt 20b der GM-Stufe 2 während dem ersten Chopping-Intervall chop über den vierten Eingangspotentialschalter 74 derart mit dem Ausgang der Hold-Schaltung 4 gekoppelt, dass die erste Feedback-Spannung an dem zweiten Eingangskontakt 20b der GM-Stufe 2 anliegt. Zudem wird während dem ersten Zeitintervall Φ1 während des zweiten Chopping-Intervalls chopb der zweite Eingangskontakt 20b der GM-Stufe 2 über den dritten Eingangspotentialschalter 73 derart mit dem Ausgang der Hold-Schaltung 4 gekoppelt, dass die zweite Feedback-Spannung an dem zweiten Eingangskontakt 20B der GM-Stufe 2 anliegt. In entsprechender Weise wird in dem ersten Zeitintervall Φ1 auch der erste Eingangskontakt 20a über den ersten Eingangspotentialschalter 71 und dem zweiten Eingangspotentialschalter 72 derart mit dem Ausgang der Hold-Schaltung 4 gekoppelt, dass in dem ersten Chopping-Zeitintervall chop die erste Feedback-Spannung an dem ersten Eingangskontakt 20a der GM-Stufe anliegt und in dem zweiten Chopping-Intervall chopb die zweite Feedback-Spannung an dem ersten Eingangskontakt 20a der GM-Stufe 2 anliegt. Somit ist die Schaltung 1 dazu eingerichtet, den zweiten Eingangskontakt 20a der GM-Stufe 2 in dem ersten Zeitintervall Φ1 des ersten Chopping-Zeitintervalls chop derart mit dem Ausgang 46a, 46b der Hold-Schaltung 4 zu koppeln, dass an diesem eine Spannung anliegt, die sich aus einer Common-Mode-Spannung Vcm zuzüglich der halben Hold-Spannung Vo_zm ergibt.

Zudem ist die Schaltung 1 somit dazu eingerichtet, den zweiten Eingangskontakt 20b der GM-Stufe 2 in dem ersten Zeitintervalls Φ1 des zweiten Chopping-Zeitintervalls chopb derart mit dem Ausgang der Hold-Schaltung 4 zu koppeln, dass an diesem eine Spannung anliegt, die sich aus der Common-Mode-Spannung Vcm abzüglich der halben Hold-Spannung Vo_zm ergibt.

In dem ersten Zeitintervall Φ1 wird während dem ersten Chopping-Zeitintervall chop durch den fünften Feedback-Schalter 65 die erste Feedback-Spannung an den ersten Sensoreingang angelegt und durch den sechsten Feedback-Schalter 66 die erste Feedback-Spannung an den zweiten Sensoreingang angelegt. In dem ersten Zeitintervall Φ1 wird während des zweiten Chopping-Zeitintervalls chopb durch den siebten Feedback-Schalter 67 die zweite Feedback-Spannung an den ersten Sensoreingang 11 angelegt und durch den achten Feedback-Schalter 68 die zweite Feedback-Spannung an den zweiten Sensoreingang 13 angelegt. Somit wird ein Potential des kapazitiven Sensors 10 abhängig von dem vorliegenden Chopping-Zeitintervall insgesamt angehoben oder abgesenkt.

Während dem zweiten Zeitintervall Φ2 wird während dem ersten Chopping-Zeitintervall chop durch den ersten Feedback-Schalter 61 eine positive Referenzspannung Vsp auf den ersten Sensoreingang 11 gelegt und die negative Referenzspannung Vsn über einen zweiten Feedback-Schalter 62 auf den zweiten Sensoreingang 13 gelegt. Währen des zweiten Zeitintervalls Φ2 wird während des zweiten Chopping-Intervalls chopb die negative Referenzspannung über den dritten Feedback-Schalter 63 auf den ersten Sensoreingang 11 gelegt und durch den vierten Feedback-Schalter 64 auf den zweiten Sensoreingang 13 gelegt. Somit wechselt abhängig von dem vorliegenden Chopping-Zeitintervall die Polarität der Eingangsspannung des kapazitiven Sensors 10.

Die Funktionsweise der in Figur 2 gezeigten Schaltung lässt sich wie folgt zusammenfassen. Eine Eingangsseite der gezeigten Schaltung 1 wird durch einen kapazitiven Sensor 10, beispielsweise durch einen einzelnen Kern eines kapazitiven MEMS-Sensors gebildet. In eine Signalverarbeitungskette folgt auf den kapazitiven Sensor 10 zunächst eine GM-Stufe 2, dann ein Integrierer 3 und zuletzt eine Hold-Schaltung 4. Der kapazitive Sensor 10 entspricht dabei einer kapazitiven Brücke. Es wird ein Delta C/C-Konzept implementiert, wobei zwei Spannungen gleicher Größe und umgekehrter Polarität an die beiden Seiten der kapazitiven Brücke angelegt werden. Ein Ausgangssignal des kapazitiven Sensors 10 ergibt sich in proportionaler Weise aus den veränderlichen Kapazitäten C1, C2 des kapazitiven Sensors 10.

Dieses Ausgangssignal, welches an dem Sensorausgang 12 bereitgestellt wird, ist proportional zu einer Beschleunigung an einer Common-mode Elektrode und somit an dem Sensorausgang 12. Das von dem kapazitiven Sensor 10 ausgegangene Signal wird durch die GM-Stufe 2 mit einer Sampling-Zeit T abgetastet, welches wiederum durch die Boxing-Kapazitäten Cbox1 und Cbox2 abgetastet werden, um in den Boxing-Kapazitäten Cbox1, Cbox2 eine Ladung zu kumulieren. Diese Ladung wird dann integriert, wobei das Integrieren durch den Integrierer 3 erfolgt und eine Verstärkung erfolgt, welche sich aus einem Verhältnis zwischen den Kapazitäten des Integrierers ergibt, insbesondere aus den Eingangskapazitäten und den Integrierkapazitäten.

Die Ausgangsspannung des Integrierers 3 wird an die Hold-Schaltung 4 übergeben, welche diese im Folgenden an den kapazitiven Sensor 10 und den Analog-Digital-Wandler 11 während des ersten Zeitintervalls Φ1 und des zweiten Zeitintervalls Φ2 bereitstellt. Die Hold-Kapazitäten werden in einem Rücksetzzeitraum rst für eine kurze Zeit zurückgesetzt, bevor ein erneuerter Ausgangswert des Integrierers 3 in einem folgenden zweiten Zeitintervall Φ2 abgegriffen wird. Diese Hold-Spannung wird zu dem kapazitiven Sensor zurückgeführt und ferner an dem Eingang der GM-Stufe 2 bereitgestellt. Somit kann eine Spannungsdifferenz des kapazitiven Sensors 10 eingestellt werden, wobei abhängig von einem vorliegenden Chopping-Zeitintervall der kapazitive Sensor 10 entweder mit der halben Hold-Spannung beaufschlagt wird oder die halbe Hold-Spannung Vo_zm von der vorliegenden Spannung abgezogen wird.

So liegt an dem ersten Sensoreingang 11 beispielsweise in dem ersten Chopping-Zeitintervall chop des zweiten Zeitintervalls Φ2 eine positive Referenzspannung Vs zuzüglich der Hold-Spannung und somit zusätzlich zu der resultierenden Ausgangsspannung Voint des Integrierers 3 an. Zugleich liegt an dem zweiten Sensoreingang 13 die negative Referenzspannung zuzüglich der Hold-Spannung Vo_zm und somit zusätzlich zu der resultierenden Ausgansspannung Voint des Integrierers 3 an.

So liegt an dem ersten Sensoreingang 11 beispielsweise in dem zweiten Chopping-Zeitintervall chopb des ersten Zeitintervalls Φ2 die positive Referenzspannung Vs abzüglich der Hold-Spannung an. Zugleich liegt an dem zweiten Sensoreingang 13 die negative Referenzspannung -Vs abzüglich der Hold-Spannung Vo_zm an.

Die Hold-Spannung Vo_zm und somit auch ein Wert der resultierenden Ausgangsspannung Voint des Integrierers 3 wird ferner an einen Analog-Digital-Wandler 11 übertragen, welcher diese Hold-Spannung digitalisiert und in einen Bitstream umsetzt. An dem Ausgang der Hold-Schaltung 4 ist die Ausgangsspannung äquivalent zu einem Wert (ΔC/ΣC) multipliziert mit der positiven Referenzspannung Vs. Der Integrierer 3 und ein Integrator des Analog-Digital-Wandlers 11, insbesondere, wenn dieser als Sigma-Delta-Modulator ausgeführt ist, führen eine Offset-Cancellation durch.

In dem ersten Zeitintervall Φ1wird die resultierende Ausgangsspannung Voint des Integrierers 3, welche von dem Integrierer 3 in einem vorangehenden Zeitintervall ausgegeben wurde, an beide Seiten der kapazitiven Brücke des kapazitiven Sensors 10 angelegt und zudem an einer Common-mode Elektrode bereitgestellt, welche den Sensorausgang 12 des kapazitiven Sensors 10 entspricht. Wird optional eine Dummy-Kapazität genutzt, so wird die negative resultierende Ausgangsspannung -Voint an dem negativen Pfad des kapazitiven Sensors 10 bereitgestellt. Durch eine Anzahl von Chopping-Schaltern wird die an dem kapazitiven Sensor 10 anliegende Spannung so geschaltet, dass wechselweise die resultierende Ausgangsspannung Voint zwischen dem ersten Sensoreingang und dem zweiten Sensoreingang 13 anliegt und in dem darauffolgenden Chopping-Zeitintervall die negative resultierende Ausgangsspannung -Voint zwischen dem ersten Sensoreingang 11 und dem zweiten Sensoreingang 13 anliegt. Ferner wird in dem ersten Zeitintervall Φ1 die GM-Stufe 2 zurückgesetzt und ein Eingang des Integrierers 3 auf die Common-mode Spannung Vcm zurückgesetzt. Der Integrierer 3 tastet die OffsetSpannung von den Offset-Kapazitäten Coff1 und Coff2 ab. Die Hold-Schaltung 4 stellt weiterhin die resultierende Ausgangsspannung Voint des Integrierers 3 aus dem vorangegangenen zweiten Zeitintervall Φ2 bereit.

In dem zweiten Zeitintervall Φ2 wird die Referenzspannung Vs an den beiden Sensoreingängen 11, 13 der kapazitiven Brücke des kapazitiven Sensors 10 bereitgestellt, wobei die positive Referenzspannung Vs (Vsp) an der ersten Kapazität C1 bereitgestellt wird und die negative Referenzspannung -Vs (Vsn) an der zweiten Kapazität C2 bereitgestellt wird. In einem folgenden Chopping-Zeitintervall wird die Polarität der Referenzspannung umgekehrt und somit die negative Referenzspannung an der ersten Kapazität C1 angelegt und die positive Referenzspannung Vs an der zweiten Kapazität C2 angelegt. Der Sensorausgang 12 wird in diesem Zustand in einem floatenden Zustand gehalten, damit die Spannung am Sensorausgang 12 sich entsprechend einem anliegenden Beschleunigungswert, durch welchen die Kapazitäten C1, C2 des kapazitiven Sensors 10 verändert werden, anpassen können. In dem zweiten Zeitintervall Φ2 wird das zuvor beschriebene Integrieren durch den Integrierer 3 ausgeführt. Die an dem kapazitiven Sensor 10 anliegenden Spannungen, also die Spannungen, die an dem ersten Sensoreingang und an dem zweiten Sensoreingang 13 anliegen, können ausgetauscht werden. So kann beispielsweise in dem ersten Zeitintervall Φ1 die positive Referenzspannung Vsp an der ersten Kapazität C1 angelegt werden und die negative Referenzspannung Vsn an die zweite Kapazität C2 des kapazitiven Sensors 10 angelegt werden, wobei in dem zweiten Zeitintervall Φ2 die resultierende Ausgangsspannung Voin entsprechender Weise invertiert an dem kapazitiven Sensor 10 angelegt werden kann.

Es wird somit durch die GM-Stufe 2 ein Boxcar-Sampling ermöglicht. Die grundlegende Idee des Boxcar-Samplings ist es, ein Rauschen aus einem Signal zu minimieren, indem das Signal über eine vorgegebene Zeit hinweg integriert wird und das Signal am Ende der Integrationsphase abgetastet wird, um dieses einer folgenden Stufe bereitzustellen und das Eingangssignal wieder zurückzusetzen. Dies entspricht somit einer gefensterten Filterung, wobei jeweils ein bestimmter Zeitraum betrachtetet wird und ein Mittelwert gebildet wird. Es wird dadurch ein besonders effektives Anti-Aliasing-Filtering ermöglicht, da ein solcher Filter ein frühes Roll-Off und periodische Nullstellen aufweist und daher ein Rauschen am Eingang einer solchen Boxcar-Funktion signifikant reduziert wird.

Bei der erfindungsgemäßen Schaltung 1 wird somit eine Abhängigkeit zwischen einem Rauschen des Integrierers 3 zu den Sensorparametern verringert, wodurch eine größere Flexibilität bei der Auswahl der Sensorkapazitäten und derer Werte und zudem bei der Auswahl der Integrierkapazitäten C1 erreicht wird. Ohne die GM-Stufe 2 wäre eine parasitäre Kapazität an einem Ausgang des kapazitiven Sensors 10 vorhanden, welche in einem Feedback-Parameter auftreten würde. Somit würde eine Dichte der abgetasteten Rauschwerte verringert und ein Feedback-Faktor würde sinken. Erfindungsgemäß wären die Sensorparameter jedoch einem Boxcar-Sampling unterzogen und dadurch deren Einfluss auf ein Rauschen verringert. Zudem wird ein Einfluss einer parasitären Kapazität des kapazitiven Sensors deutlich verringert, da die GM-Stufe 2 vor dem Integrierer 3 angeordnet ist. Zudem wird ein Rauschen des Integrierers 3 nun durch eine Verstärkung der GM-Stufe deutlich reduziert, wodurch wiederum ein Beitrag des Integrierers 3 zu einem Rauschen der gesamten Schaltung 1 verringert wird. Zudem werden die Verstärkungsanforderungen an die Verstärkerstufe des Integrierers 3 verringert, da eine notwendige Verstärkung aus einer Kombination der Verstärker der GM-Stufe 2 und des Integrierers 3 erreicht werden kann, wodurch die Anforderungen an die integrierenden Kapazitäten des Integrierers 3 verringert werden.

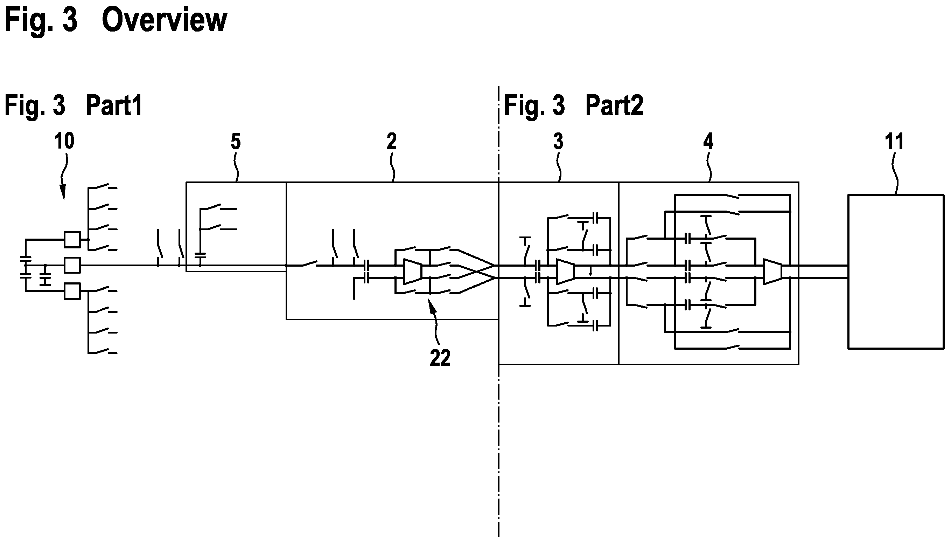

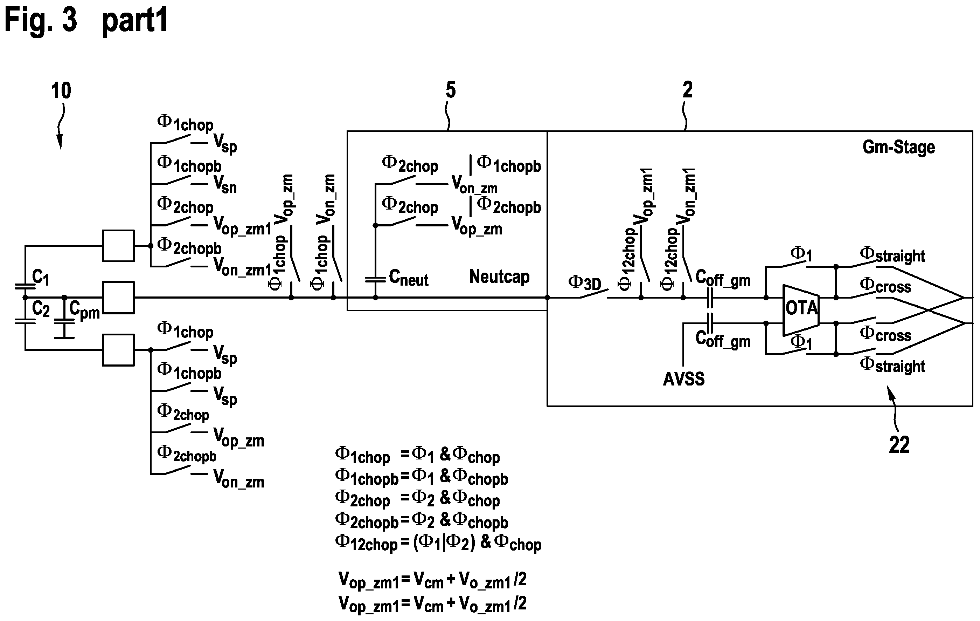

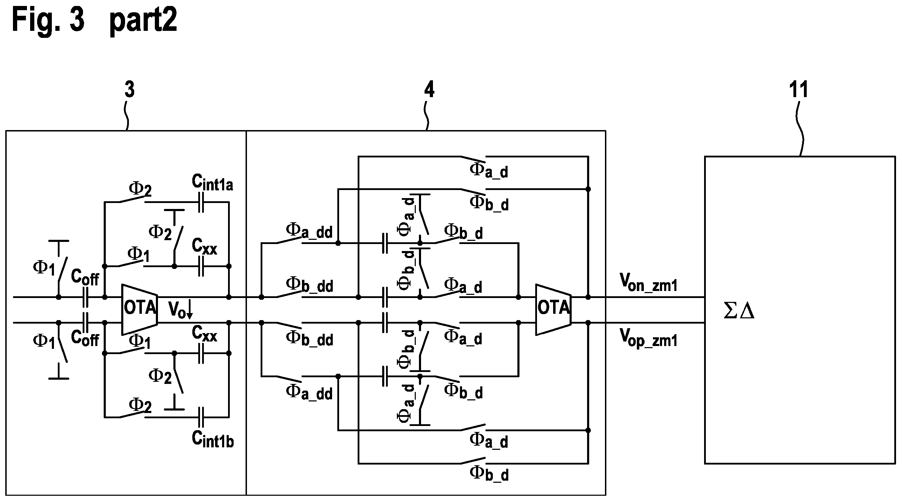

Figur 3 zeigt eine weitere Ausführungsform der Erfindung. Das Grundprinzip der in Figur 3 gezeigten Schaltung entspricht der in Figur 2 gezeigten Schaltung.

Dabei sind jedoch an einem Ausgang der GM-Stufe 2 die Boxing-Kapazitäten Cbox1, Cbox2 und an einem Eingang des Integrierers 3 die Eingangskapazitäten Cin1, Cin2 entfernt. Dies hat den Vorteil, dass der Ausgang 30a, 30b der GM-Stufe 2 zu jedem Zeitpunkt auf einer virtuellen Masse liegt und die Verstärkung der GM Stufe 2 stabil ist. Die Funktion der Boxing-Kapazitäten Cbox1, Cbox2 wird durch die Integrierkapazitäten Cint1a, Cint1b übernommen.

Bei diesem Aufbau kann eine Stabilität der Schaltung nur durch die Integrierkapazitäten Cint1a, Cint1b gewährleistet werden, was gegenüber dem Aufbau mit den dedizierten Boxingkapazitäten Cbox1, Cbox2 und den Eingangskapazitäten Cin1, Cin2 weniger Flexibilität ermöglicht. Im Übrigen bleibt das Verhalten der Schaltung 1 jedoch über der in Figur zwei gezeigten Ausführungsform gleich.

Ein weiterer Unterschied ist, dass die Dummy-Kapazitäten entfernt wurden und eine Common-Mode Spannung Vcm der Schaltung 1 an den zweiten Eingangskontakt 20b der GM-Stufe 2 angelegt ist. Dies führt zu einer weiteren Verringerung eines Rauschens der Schaltung 1.

Die in Figur drei gezeigte Schaltung kann dabei in drei Phasen betrieben werden. Dabei ist ein Zeitsignal in drei Phasen oder Zeitintervalle unterteilt. In dem ersten Zeitintervall Φ1 erfolgt eine Offset-Cancellation in dem Integrierer 3 und der Offset des Integrierers 3 wird durch die Offset-Kapazitäten Coff und die weiteren Kapazitäten Cxx abgetastet.

Der Chopping-Circuit 22 auf der Ausgangsseite der GM-Stufe 2 ist so modifiziert, dass diese nicht nur abhängig von Chopping-Zeitintervallen chop, chopb arbeiten, sondern auch abhängig von dem zweiten Zeitintervall Φ2 und einem dritten Zeitintervall Φ3 arbeiten. Dadurch wird es ermöglicht, ein Vorzeichen des integrierten Signals zu verändern. So wird in dem zweiten Zeitintervall Φ2 nur der Offset integriert und in dem dritten Zeitintervall Φ3 wird der Offset und das Signal integriert, jedoch mit umgekehrten Vorzeichen wie in dem zweiten Zeitintervall Φ2. Die Hold-Schaltung 4 erfasst die Ausgangsspannung des Integrierers 4 in dem dritten Zeitintervall Φ3 und hält diese zumindest in dem ersten und dem zweiten Zeitintervall Φ1, Φ2, so dass diese verwendet werden kann, um die Feedbackspannungen zu dem kapazitiven Sensor 11 und dem Eingang der GM-Stufe2 bereitzustellen. Optional werden so auch die Feedbackspannungen zu den Neutralisierungskapazitäten 5 bereitgestellt.

Die erfindungsgemäße Schaltung 1 ist bevorzugt eine Ausleseschaltung oder Treiberschaltung für einen Beschleunigungssensor, kann jedoch auch eine Ausleseschaltung für ein Gyroskop oder einen anderen kapazitiven Sensor sein.

Neben der oben stehender Offenbarung wird explizit auf die Offenbarung der Figuren 1 bis 3 verwiesen.

## Patentansprüche

1. Schaltung (1) zum Betreiben eines kapazitiven Sensors (10), welche dazu eingerichtet ist, wechselweise über ein erstes Zeitintervall (Φ1) in einem ersten Modus und über ein zweites Zeitintervall (Φ2) in einem zweiten Modus betrieben zu werden, umfassend:
- eine GM-Stufe (2) mit einem ersten Eingangskontakt (20A) und einem zweiten Eingangskontakt (20B), welche dazu eingerichtet ist, an dem ersten Eingangskontakt (20A) der GM-Stufe (2) eine Sensorspannung des kapazitiven Sensors (10) zu empfangen und die Sensorspannung in einen Sensorstrom umzusetzen, um in dem zweiten Zeitintervall (Φ2) eine erste Boxing-Kapazität (Cbox1) durch den Sensorstrom zu laden;
- einen Integrierer (3), welcher dazu eingerichtet ist, in dem zweiten Zeitintervall (Φ2) eine über die erste Boxing-Kapazität (Cbox1) anliegende Spannung über deren zeitlichen Verlauf hinweg zu integrieren und an einem ersten Ausgang (35A, 35B) des Integrierers (3) eine daraus resultierende Ausgangsspannung (Voint) auszugeben;
- eine Hold-Schaltung (4), welche dazu eingerichtet ist, in dem zweiten Zeitintervall (Φ2) die Ausgangsspannung (Voint) des Integrierers (3) abzugreifen und an einem Ausgang (46A, 46B) der Hold-Schaltung (4) als Hold-Spannung (Vo_zm) zu halten,
wobei die Schaltung (1) dazu eingerichtet ist,
- in dem ersten und/oder in dem zweiten Zeitintervall (Φ1, Φ2) die Hold-Spannung (Vo_zm) dem kapazitiven Sensor (10) als Feedbackspannung und einem Analog-Digital-Wandler (11) als zu wandelnde Eingangsspannung bereitzustellen, und
- die erste Boxing-Kapazität (Cbox1) in dem ersten Zeitintervall (Φ1) zu entladen,
wobei die Schaltung (1) dazu eingerichtet ist:
den zweiten Eingangskontakt (20B) der GM-Stufe (2) in dem zweiten Zeitintervall (Φ2) in einen floatenden Zustand zu schalten oder in dem zweiten Zeitintervall (Φ2) über eine Massekapazität (75) mit einer Schaltungsmasse (80) zu koppeln, und den zweiten Eingangskontakt (20B) der GM-Stufe (2) in dem ersten Zeitintervall (Φ1) mit dem Ausgang (46A, 46B) der Hold-Schaltung (4) zu koppeln.

2. Schaltung (1) nach Anspruch 1, **dadurch gekennzeichnet, dass** die GM-Stufe (2), der Integrierer (3) und die Hold-Schaltung (4) differentielle Schaltungen sind.

3. Schaltung (1) nach einem der voranstehenden Ansprüche, **dadurch gekennzeichnet, dass**
- die GM-Stufe (2) ferner einen Chopping-Circuit (22) umfasst, welcher dazu eingerichtet ist, den Sensorstrom in einem ersten Chopping-Zeitintervall (chop) an die erste Boxing-Kapazität (Cbox1) und in einem zweiten Chopping-Zeitintervall (chopb) an eine zweite Boxing-Kapazität (Cbox2) zu leiten, um die Boxing-Kapazitäten (Cbox1, Cbox2) in dem zweiten Zeitintervall (Φ2) des jeweiligen Chopping-Zeitintervalls (chop, chopb) durch den Sensorstrom zu laden.

4. Schaltung (1) nach Anspruch 3, **dadurch gekennzeichnet, dass** die Schaltung (1) dazu eingerichtet ist,
- den zweiten Eingangskontakt (20B) der GM-Stufe (2) in demersten Zeitintervall (Φ1) des ersten Chopping-Zeitintervalls (chop) derart über einen Feedbackpfad mit dem Ausgang (46A, 46B) der Hold-Schaltung (4) zu koppeln, dass an diesem eine Spannung anliegt, die sich aus einer Common-Mode-Spannung zuzüglich der halben Hold-Spannung (Vo_zm) ergibt, und
- den zweiten Eingangskontakt (20B) der GM-Stufe (2) in dem ersten Zeitintervall (Φ1) des zweiten Chopping-Zeitintervalls (chopb) derart über einen Feedbackpfad mit dem Ausgang der Hold-Schaltung (4) zu koppeln, dass an diesem eine Spannung anliegt, die sich aus der Common-Mode-Spannung abzüglich der halben Hold-Spannung (Vo_zm) ergibt.

5. Schaltung (1) nach einem der voranstehenden Ansprüche, **dadurch gekennzeichnet, dass** die Schaltung (1) eine Neutralisierungskapazität (51) umfasst, wobei eine erste Seite der Neutralisierungskapazität (51) mit dem ersten Eingangskontakt (20A) der GM-Stufe (2) gekoppelt ist und eine zweite Seite der Neutralisierungskapazität dazu eingerichtet ist, wahlweise
- derart mit dem Ausgang (46A, 46B) der Hold-Schaltung (4) gekoppelt zu werden, dass an der zweiten Seite der Neutralisierungskapazität (51) eine Spannung anliegt, die sich aus ein Common-Mode-Spannung zuzüglich der halben Hold-Spannung (Vo_zm) ergibt, oder
- derart mit dem Ausgang (46A, 46B) der Hold-Schaltung (4) gekoppelt zu werden, dass an der zweiten Seite der Neutralisierungskapazität (51) eine Spannung anliegt, die sich aus der Common-Mode-Spannung abzüglich der halben Hold-Spannung (Vo_zm) ergibt.

6. Schaltung (1) nach einem der voranstehenden Ansprüche, **dadurch gekennzeichnet, dass** die erste Boxing-Kapazität (Cbox1) und/oder die zweite Boxing-Kapazität (Cbox2) eine Kapazität des Integrierers (3) ist.

7. Schaltung (1) nach einem der voranstehenden Ansprüche, **dadurch gekennzeichnet, dass** der kapazitive Sensor (10) ein MEMS-Sensor, insbesondere ein Beschleunigungssensor oder ein MEMS-Gyroskop ist.

8. Sensorvorrichtung (100), umfassend die Schaltung (1) nach einem der voranstehenden Ansprüche und den kapazitiven Sensor (10), wobei der kapazitive Sensor (10) zwei kapazitive Elemente (C1, C2) umfasst, die zu einer Brücke verschaltet sind und ein gemeinsames Potential (12) der kapazitiven Elemente (C1, C2) mit dem ersten Eingangskontakt (20A) der GM-Stufe (2) gekoppelt ist und die außenliegenden Kontakte (11, 13) der Brücke mit Ausgang (46A, 46B) der Hold-Schaltung (4) gekoppelt sind, um mit der Hold-Spannung (Vo_zm) beaufschlagt zu werden.

## Claims

1. Circuit (1) for operating a capacitive sensor (10) that is configured to be operated alternately in a first mode over a first time interval (Φ1) and in a second mode over a second time interval (Φ2), comprising:
- a GM stage (2), having a first input contact (20A) and a second input contact (20B), which is configured to receive a sensor voltage of the capacitive sensor (10) at the first input contact (20A) of the GM stage (2) and to convert the sensor voltage into a sensor current in order to charge a first boxing capacitor (Cbox1) using the sensor current in the second time interval (Φ2);
- an integrator (3), which is configured to time-integrate a voltage across the first boxing capacitor (Cbox1) in the second time interval (Φ2) and to output a resulting output voltage (Voint) at a first output (35A, 35B) of the integrator (3);
- a hold circuit (4), which is configured to sample the output voltage (Voint) of the integrator (3) in the second time interval (Φ2) and to hold it at an output (46A, 46B) of the hold circuit (4) as a hold voltage (Vo_zm),
wherein the circuit (1) is configured
- to provide the hold voltage (Vo_zm) to the capacitive sensor (10) as feedback voltage, and to an analogue-to-digital converter (11) as input voltage to be converted, in the first and/or in the second time interval (Φ1, Φ2), and
- to discharge the first boxing capacitor (Cbox1) in the first time interval (Φ1),
wherein the circuit (1) is configured
to switch the second input contact (20B) of the GM stage (2) to a floating state in the second time interval (Φ2), or to couple it via an earth capacitor (75) to a circuit earth (80) in the second time interval (Φ2), and to couple the second input contact (20B) of the GM stage (2) to the output (46A, 46B) of the hold circuit (4) in the first time interval (Φ1).

2. Circuit (1) according to Claim 1, **characterized in that** the GM stage (2), the integrator (3) and the hold circuit (4) are differential circuits.

3. Circuit (1) according to either of the preceding claims, **characterized in that**
- the GM stage (2) also comprises a chopping circuit (22), which is configured to conduct the sensor current to the first boxing capacitor (Cbox1) in a first chopping time interval (chop) and to a second boxing capacitor (Cbox2) in a second chopping time interval (chopb) in order to charge the boxing capacitors (Cbox1, Cbox2) using the sensor current in the second time interval (Φ2) of the respective chopping time interval (chop, chopb).

4. Circuit (1) according to Claim 3, **characterized in that** the circuit (1) is configured
- to couple the second input contact (20B) of the GM stage (2) via a feedback path to the output (46A, 46B) of the hold circuit (4) in the first time interval (Φ1) of the first chopping time interval (chop) in such a way that a voltage that results from a common mode voltage plus half the hold voltage (Vo_zm) is present at said output, and
- to couple the second input contact (20B) of the GM stage (2) via a feedback path to the output of the hold circuit (4) in the first time interval (Φ1) of the second chopping time interval (chopb) in such a way that a voltage that results from the common mode voltage minus half the hold voltage (Vo_zm) is present at said output.

5. Circuit (1) according to one of the preceding claims, **characterized in that** the circuit (1) comprises a neutralization capacitor (51), wherein a first side of the neutralization capacitor (51) is coupled to the first input contact (20A) of the GM stage (2) and a second side of the neutralization capacitor is configured, either
- to be coupled to the output (46A, 46B) of the hold circuit (4) in such a way that a voltage that results from a common mode voltage plus half the hold voltage (Vo_zm) is present at the second side of the neutralization capacitor (51), or
- to be coupled to the output (46A, 46B) of the hold circuit (4) in such a way that a voltage that results from the common mode voltage minus half the hold voltage (Vo_zm) is present at the second side of the neutralization capacitor (51).

6. Circuit (1) according to one of the preceding claims, **characterized in that** the first boxing capacitor (Cbox1) and/or the second boxing capacitor (Cbox2) is a capacitor of the integrator (3).

7. Circuit (1) according to one of the preceding claims, **characterized in that** the capacitive sensor (10) is a MEMS sensor, in particular an acceleration sensor or a MEMS gyroscope.

8. Sensor device (100), comprising the circuit (1) according to one of the preceding claims and the capacitive sensor (10), wherein the capacitive sensor (10) comprises two capacitive elements (C1, C2), which are connected to form a bridge, and a common potential (12) of the capacitive elements (C1, C2) is coupled to the first input contact (20A) of the GM stage (2) and the external contacts (11, 13) of the bridge are coupled to the output (46A, 46B) of the hold circuit (4) in order for the hold voltage (Vo_zm) to be applied thereto.

## Revendications

1. Circuit (1) pour faire fonctionner un capteur capacitif (10), qui est mis au point pour fonctionner alternativement dans un premier mode sur un premier intervalle de temps (Φ1) et dans un deuxième mode sur un deuxième intervalle de temps (Φ2), comprenant :
- un étage GM (2) avec un premier contact d'entrée (20A) et un deuxième contact d'entrée (20B), qui est mis au point pour recevoir une tension de capteur du capteur capacitif (10) sur le premier contact d'entrée (20A) de l'étage GM (2) et pour convertir la tension de capteur en un courant de capteur pour charger une première capacité d'encaissage (Cbox1) par le courant du capteur dans le deuxième intervalle de temps (Φ2) ;
- un intégrateur (3), qui est mis au point pour intégrer une tension appliquée par la première capacité d'encaissage (Cbox1) sur la courbe temporelle de celle-ci dans le deuxième intervalle de temps (Φ2) et pour délivrer une tension de sortie (Voint) résultant de celle-ci sur une première sortie (35A, 35B) de l'intégrateur (3) ;
- un circuit de maintien (4), qui est mis au point pour prélever la tension de sortie (Voint) de l'intégrateur (3) dans le deuxième intervalle de temps (Φ2) et pour la maintenir comme tension de maintien (Vo_zm) sur une sortie (46A, 46B) du circuit de maintien (4),
le circuit (1) étant mis au point pour
- fournir, dans le premier et/ou dans le deuxième intervalle de temps (Φ1, Φ2), la tension de maintien (Vo_zm) au capteur capacitif (10) en tant que tension de rétroaction et à un convertisseur analogique-numérique (11) en tant que tension d'entrée à convertir, et
- décharger la première capacité d'encaissage (Cbox1) dans le premier intervalle de temps (Φ1),
le circuit (1) étant mis au point pour :
commuter le deuxième contact d'entrée (20B) de l'étage GM (2) dans un état flottant dans le deuxième intervalle de temps (Φ2) ou le coupler à une masse de circuit (80) par une capacité de masse (75) dans le deuxième intervalle de temps (Φ2), et coupler le deuxième contact d'entrée (20B) de l'étage GM (2) à la sortie (46A, 46B) du circuit de maintien (4) dans le premier intervalle de temps (Φ1).

2. Circuit (1) selon la revendication 1, **caractérisé en ce que** l'étage GM (2), l'intégrateur (3) et le circuit de maintien (4) sont des circuits différentiels.

3. Circuit (1) selon l'une des revendications précédentes, **caractérisé en ce que**
- l'étage GM (2) comprend en outre un circuit de découpage (22) qui est mis au point pour conduire le courant de capteur vers la première capacité d'encaissage (Cbox1) dans un premier intervalle de temps de découpage (chop) et vers une deuxième capacité d'encaissage (Cbox2) dans un deuxième intervalle de temps de découpage (chopb) pour charger les capacités d'encaissage (Cbox1, Cbox2) dans le deuxième intervalle de temps (Φ2) de l'intervalle de temps de découpage (chop, chopb) respectif par le courant du capteur.

4. Circuit (1) selon la revendication 3, **caractérisé en ce que** le circuit (1) est mis au point pour
- coupler le deuxième contact d'entrée (20B) de l'étage GM (2) dans le premier intervalle de temps (Φ1) du premier intervalle de temps de découpage (chop) par une voie de rétroaction à la sortie (46A, 46B) du circuit de maintien (4) de telle manière qu'une tension résultant d'une tension de mode commun plus la moitié de la tension de maintien (Vo_zm) est appliquée sur celle-ci, et
- coupler le deuxième contact d'entrée (20B) de l'étage GM (2) dans le premier intervalle de temps (Φ1) du deuxième intervalle de temps de découpage (chopb) par une voie de rétroaction à la sortie du circuit de maintien (4) de telle manière qu'une tension résultant de la tension de mode commun moins la moitié de la tension de maintien (Vo_zm) est appliquée sur celle-ci.

5. Circuit (1) selon l'une des revendications précédentes, **caractérisé en ce que** le circuit (1) comprend une capacité de neutralisation (51), un premier côté de la capacité de neutralisation (51) étant couplé au premier contact d'entrée (20A) de l'étage GM (2) et un deuxième côté de la capacité de neutralisation étant mis au point de manière sélective pour
- être couplé à la sortie (46A, 46B) du circuit de maintien (4) de telle manière qu'une tension résultant d'une tension de mode commun plus la moitié de la tension de maintien (Vo_zm) est appliquée sur le deuxième côté de la capacité de neutralisation (51), ou
- être couplé à la sortie (46A, 46B) du circuit de maintien (4) de telle manière qu'une tension résultant de la tension de mode commun moins la moitié de la tension de maintien (Vo_zm) est appliquée sur le deuxième côté de la capacité de neutralisation (51).

6. Circuit (1) selon l'une des revendications précédentes, **caractérisé en ce que** la première capacité d'encaissage (Cbox1) et/ou la deuxième capacité d'encaissage (Cbox2) sont une capacité de l'intégrateur (3).

7. Circuit (1) selon l'une des revendications précédentes, **caractérisé en ce que** le capteur capacitif (10) est un capteur MEMS, en particulier un capteur d'accélération ou un gyroscope MEMS.

8. Dispositif capteur (100) comprenant le circuit (1) selon l'une des revendications précédentes et le capteur capacitif (10), le capteur capacitif (10) comprenant deux éléments capacitifs (C1, C2) qui sont connectés en un pont et un potentiel commun (12) des éléments capacitifs (C1, C2) étant couplé au premier contact d'entrée (20A) de l'étage GM (2), et les contacts externes (11, 13) du pont étant couplés à la sortie (46A, 46B) du circuit de maintien (4) pour être soumis à l'action de la tension de maintien (Vo_zm).
